# EUROPEAN PATENT APPLICATION

(11) **EP 4 283 877 A2**
(43) Date of publication of application: **29.11.2023**
(21) Application number: 23195286.2
(22) Date of filing: 07.06.2019
(51) Int. Cl.: H03M 7/30

(54) **ENCODER AND ENCODING METHOD, DECODER AND DECODING METHOD, AND PROGRAM**

(30) Priority: 21.06.2018 JP 2018117635
(62) Divisional of application: 19822562.5
(71) Applicant: Sony Group Corporation, Tokyo 108-0075 (JP)
(72) Inventor: KONO, Akifumi, Tokyo, 108-0075 (JP); CHINEN, Toru, Tokyo, 108-0075 (JP); HONMA, Hiroyuki, Tokyo, 108-0075 (JP); OIKAWA, Yoshiaki, Tokyo, 108-0075 (JP)
(74) Representative: 2SPL Patentanwälte PartG mbB

(57) **Abstract**

Provided is a decoding device including a demultiplexing section configured to demultiplex a coded bit stream, and extract transform window information indicating a type of a transform window used in time-frequency transform of an audio signal and coded data regarding frequency spectrum information obtained by the time-frequency transform from the coded bit stream. The decoding device further includes a decoding section configured to decode the coded data. Additionally, the decoding device includes a decoding scheme selection section configured to select a decoding scheme for the decoding section based on the transform window information. The decoding scheme selection section is configured to control the decoding section to decode the coded data by a decoding scheme corresponding to Huffman coding in a case in which the type of the transform window indicated by the transform window information is a transform window selected at a time of changing over the transform window length from a small transform window length to a large transform window length. Furthermore, the decoding scheme selection section is configured to control the decoding section to decode the coded data by a decoding scheme corresponding to arithmetic coding in a case in which the type of the transform window indicated by the transform window information is not the transform window selected at the time of changing over the transform window length from the small transform window length to the large transform window length.

## Description

### [Technical Field]

The present technology relates to a coding device, a coding method, a decoding device, a decoding method, and a program, and particularly relates to a coding device, a coding method, a decoding device, a decoding method, and a program capable of improving coding efficiency.

### [Background Art]

As methods of coding an audio signal, there are known, for example, coding or the like according to the MPEG (Moving Picture Experts Group)-2 AAC (Advanced Audio Coding) standard, the MPEG-4 AAC standard, the MPEG-D USAC (Unified Speech and Audio Coding) standard, and the MPEG-H 3D audio standard using the MPEG-D USAC standard as a Core Coder, which are international standards (refer to, for example, NPLs 1 and 2).

### [Citation List]

### [Non Patent Literature]

[NPL 1]
   INTERNATIONAL STANDARD ISO/IEC 14496-3 Fourth edition 2009-09-01 Information technology-coding of audio-visual objects-part3: Audio
[NPL 2]
   INTERNATIONAL STANDARD ISO/IEC 23003-3 Frist edition 2012-04-01 Information technology-coding of audio-visual objects-part3:Unified speech and audio coding

### [Summary]

### [Technical Problem]

Meanwhile, to transmit many sound materials (objects) realized by reproduction having more enhanced presence than that of conventional 7.1 surround sound reproduction or "3D audio," it is necessary to use a coding technology capable of decoding more audio channels with higher compression efficiency at a higher speed. In other words, improved coding efficiency is desired.

The present technology has been achieved in light of such a circumstance, and an object of the present technology is to enable improved coding efficiency.

### [Solution to Problem]

A coding device according to a first aspect of the present technology includes a time-frequency transform section that performs time-frequency transform using a transform window on an audio signal, and a coding section that performs Huffman coding on frequency spectrum information obtained by the time-frequency transform in a case in which a transform window length of the transform window is changed over from a small transform window length to a large transform window length, and that performs arithmetic coding on the frequency spectrum information in a case in which the transform window length of the transform window is not changed over from the small transform window length to the large transform window length.

A coding method or a program according to the first aspect of the present technology includes performing time-frequency transform using a transform window on an audio signal, performing Huffman coding on frequency spectrum information obtained by the time-frequency transform in a case in which a transform window length of the transform window is changed over from a small transform window length to a large transform window length, and performing arithmetic coding on the frequency spectrum information in a case in which the transform window length of the transform window is not changed over from the small transform window length to the large transform window length.

According to the first aspect of the present technology, time-frequency transform using a transform window is performed on an audio signal, Huffman coding is performed on frequency spectrum information obtained by the time-frequency transform in a case in which a transform window length of the transform window is changed over from a small transform window length to a large transform window length, and arithmetic coding is performed on the frequency spectrum information in a case in which the transform window length of the transform window is not changed over from the small transform window length to the large transform window length.

A decoding device according to a second aspect of the present technology includes a demultiplexing section that demultiplexes a coded bit stream, and that extracts transform window information indicating a type of a transform window used in time-frequency transform of an audio signal and coded data regarding frequency spectrum information obtained by the time-frequency transform from the coded bit stream, and a decoding section that decodes the coded data by a decoding scheme corresponding to Huffman coding in a case in which the transform window indicated by the transform window information is the transform window selected at a time of changing over the transform window length from a small transform window length to a large transform window length.

A decoding method or a program according to the second aspect of the present technology includes the steps of demultiplexing a coded bit stream, and extracting transform window information indicating a type of a transform window used in time-frequency transform of an audio signal and coded data regarding frequency spectrum information obtained by the time-frequency transform from the coded bit stream, and decoding the coded data by a decoding scheme corresponding to Huffman coding in a case in which the transform window indicated by the transform window information is the transform window selected at a time of changing over the transform window length from a small transform window length to a large transform window length.

According to the second aspect of the present technology, a coded bit stream is demultiplexed, transform window information indicating a type of a transform window used in time-frequency transform of an audio signal and coded data regarding frequency spectrum information obtained by the time-frequency transform are extracted from the coded bit stream, and the coded data is decoded by a decoding scheme corresponding to Huffman coding in a case in which the transform window indicated by the transform window information is the transform window selected at a time of changing over the transform window length from a small transform window length to a large transform window length.

### [Advantageous Effect of Invention]

According to the first and second aspects of the present technology, it is possible to improve coding efficiency.

It is noted that advantages are not always limited to those described herein but may be any of advantageous effects described in the present disclosure.

### [Brief Description of Drawings]

[FIG. 1]

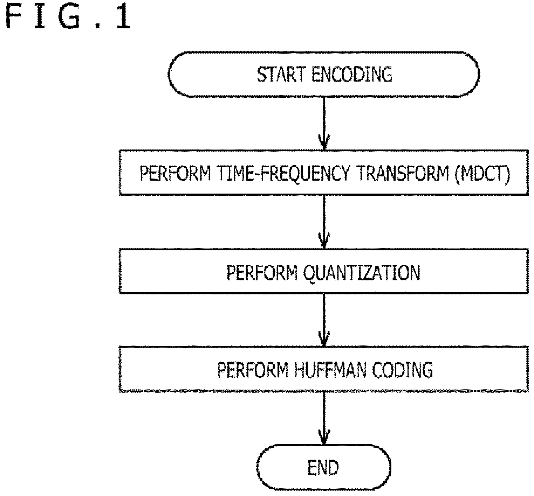

   FIG. 1 is an explanatory diagram of MPEG-4 AAC coding.
[FIG. 2]

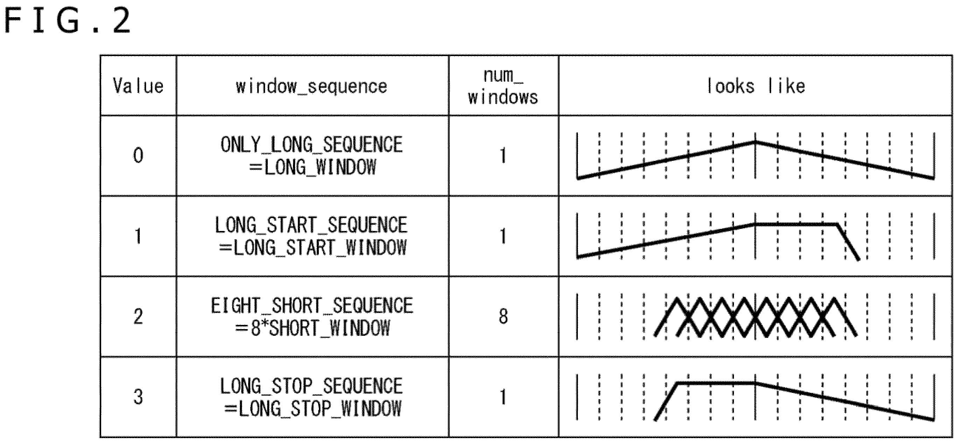

   FIG. 2 is an explanatory diagram of types of a transform window in MPEG-4 AAC.
[FIG. 3]

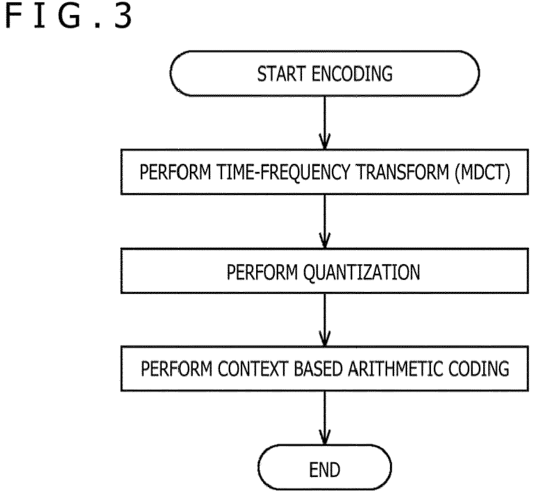

   FIG. 3 is an explanatory diagram of MPEG-D USAC coding.
[FIG. 4]

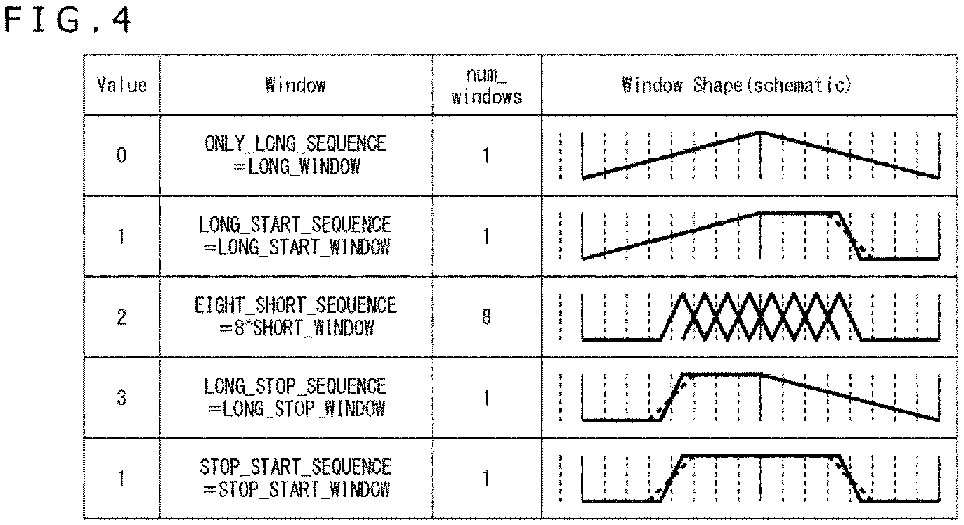

   FIG. 4 is an explanatory diagram of types of a transform window in MPEG-D USAC.
[FIG. 5]

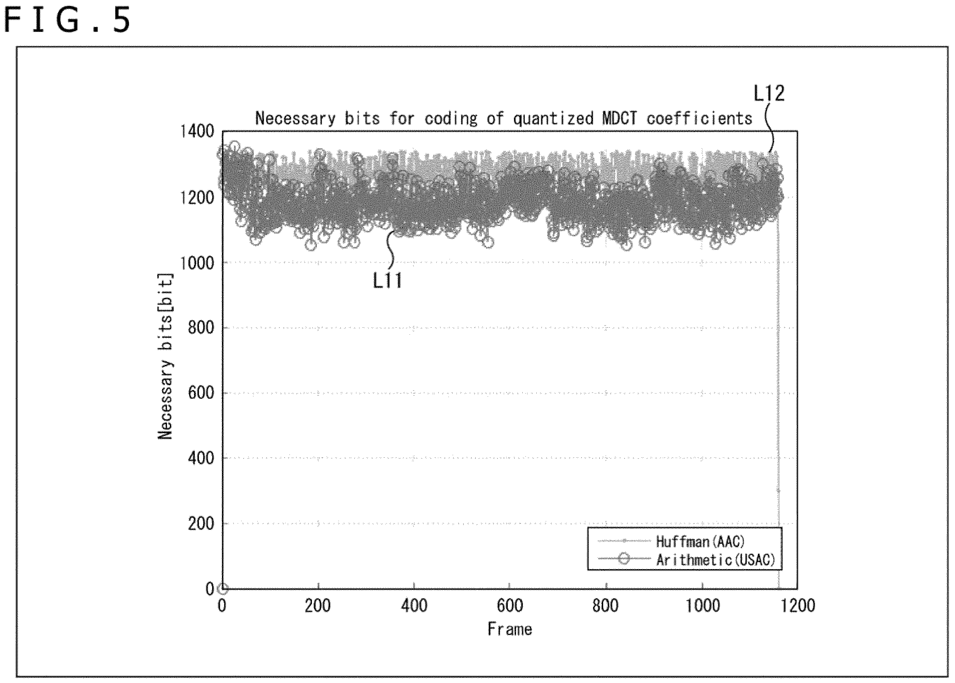

   FIG. 5 is an explanatory diagram of coding efficiencies of Huffman coding and arithmetic coding.
[FIG. 6]

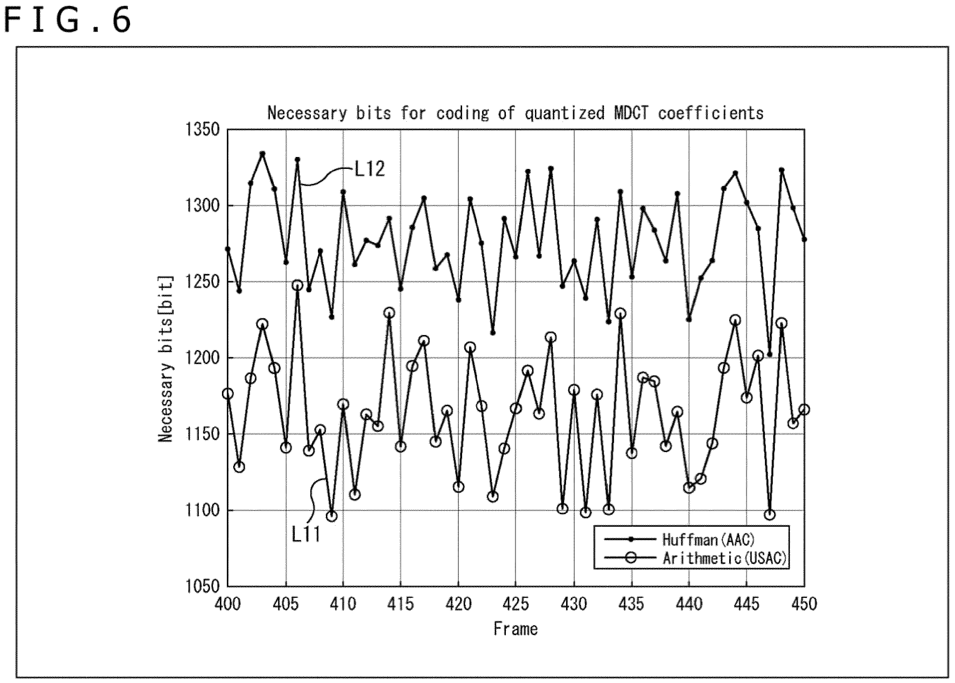

   FIG. 6 is an explanatory diagram of coding efficiencies of Huffman coding and arithmetic coding.
[FIG. 7]

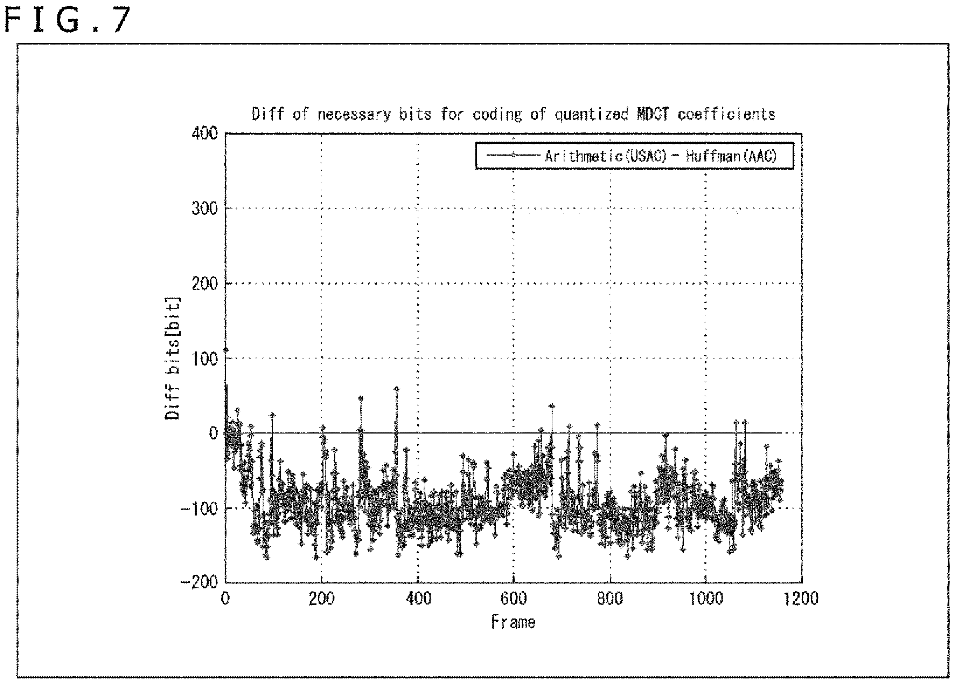

   FIG. 7 is an explanatory diagram of coding efficiencies of Huffman coding and arithmetic coding.
[FIG. 8]

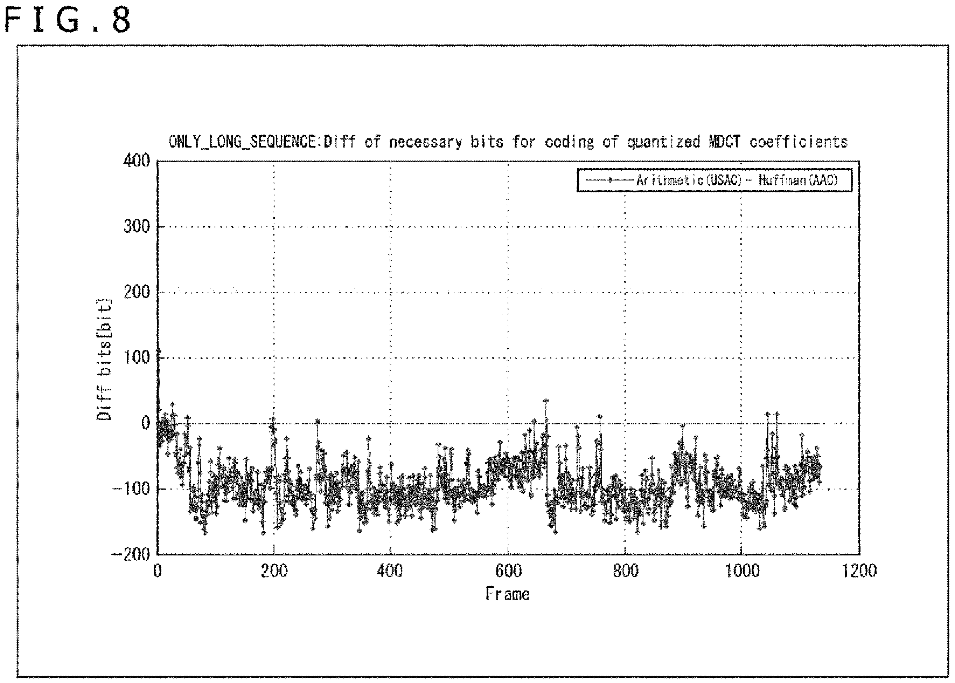

   FIG. 8 is an explanatory diagram of coding efficiencies of Huffman coding and arithmetic coding.
[FIG. 9]

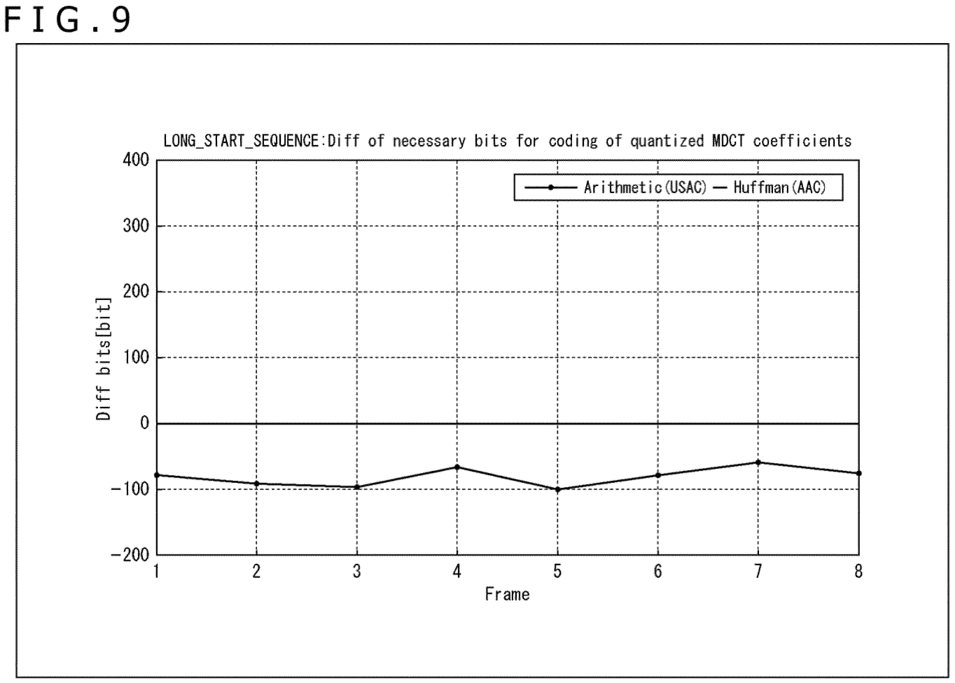

   FIG. 9 is an explanatory diagram of coding efficiencies of Huffman coding and arithmetic coding.
[FIG. 10]

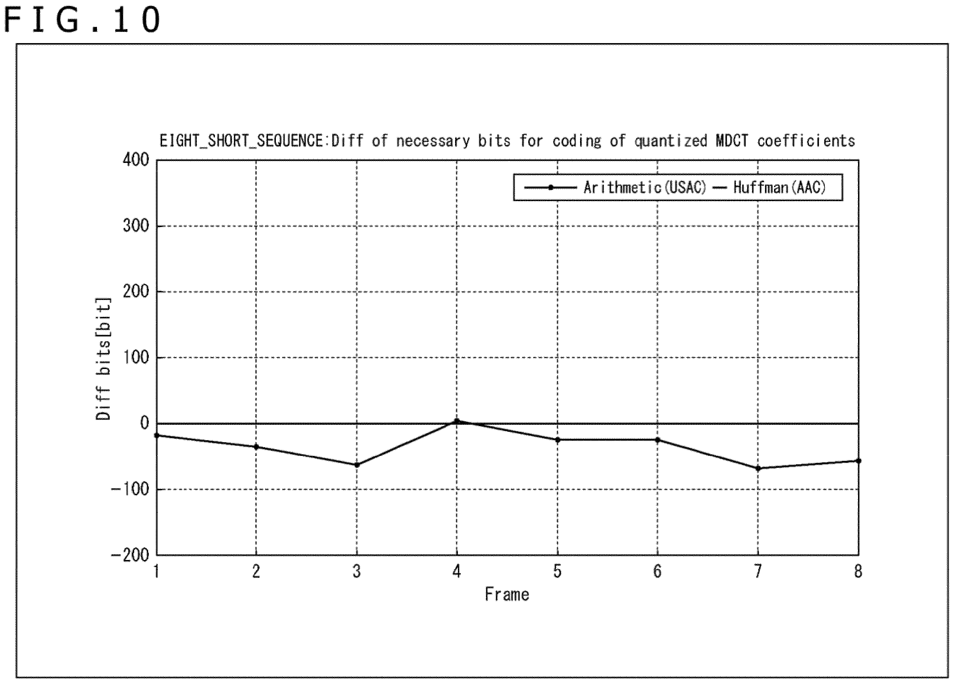

   FIG. 10 is an explanatory diagram of coding efficiencies of Huffman coding and arithmetic coding.
[FIG. 11]

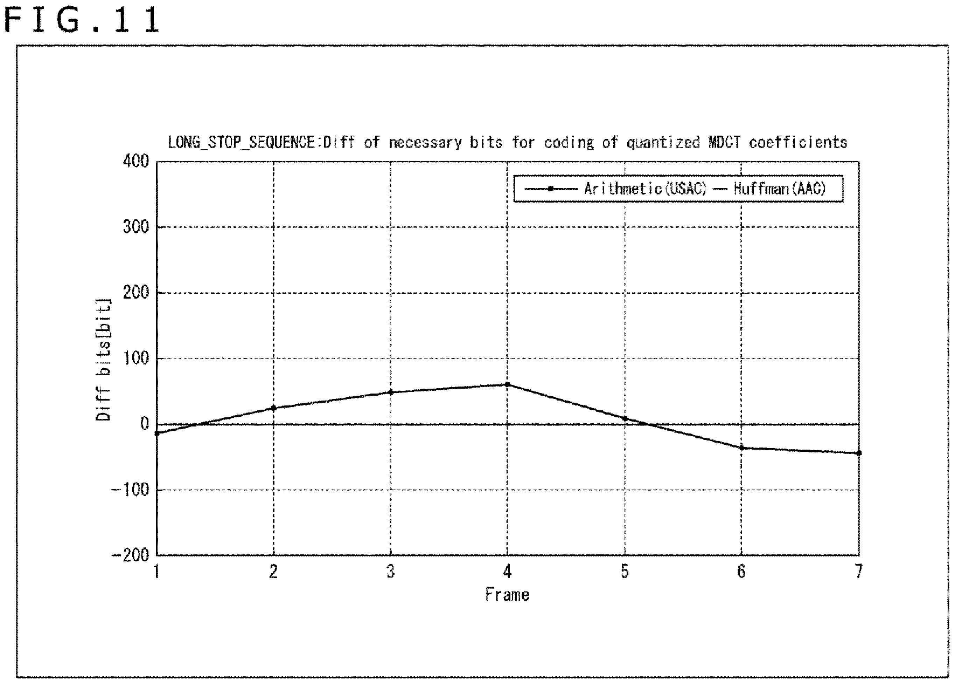

   FIG. 11 is an explanatory diagram of coding efficiencies of Huffman coding and arithmetic coding.
[FIG. 12]

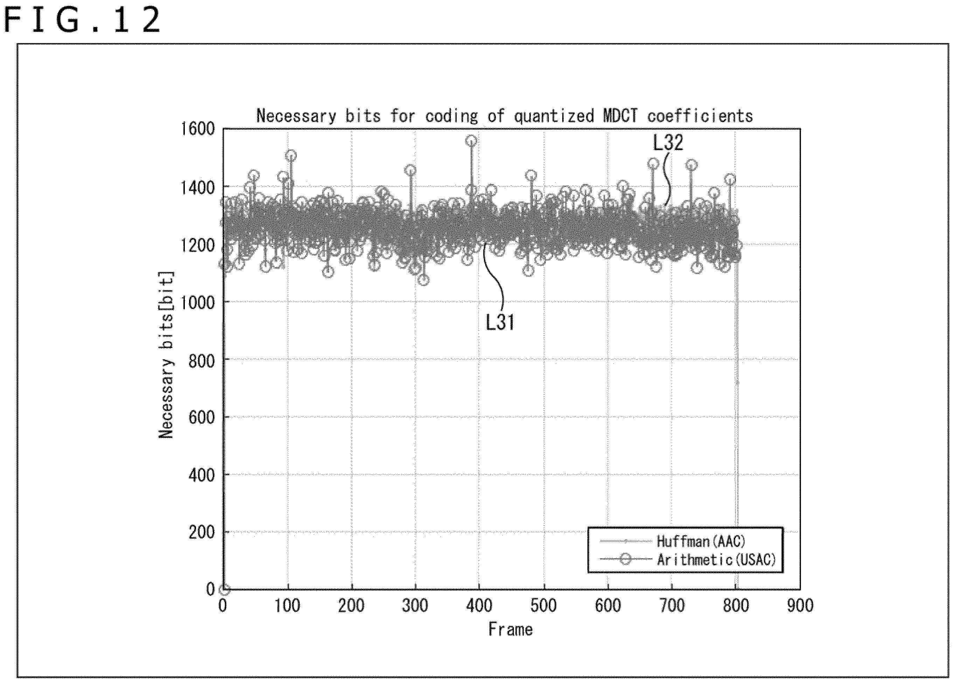

   FIG. 12 is an explanatory diagram of coding efficiencies of Huffman coding and arithmetic coding.
[FIG. 13]

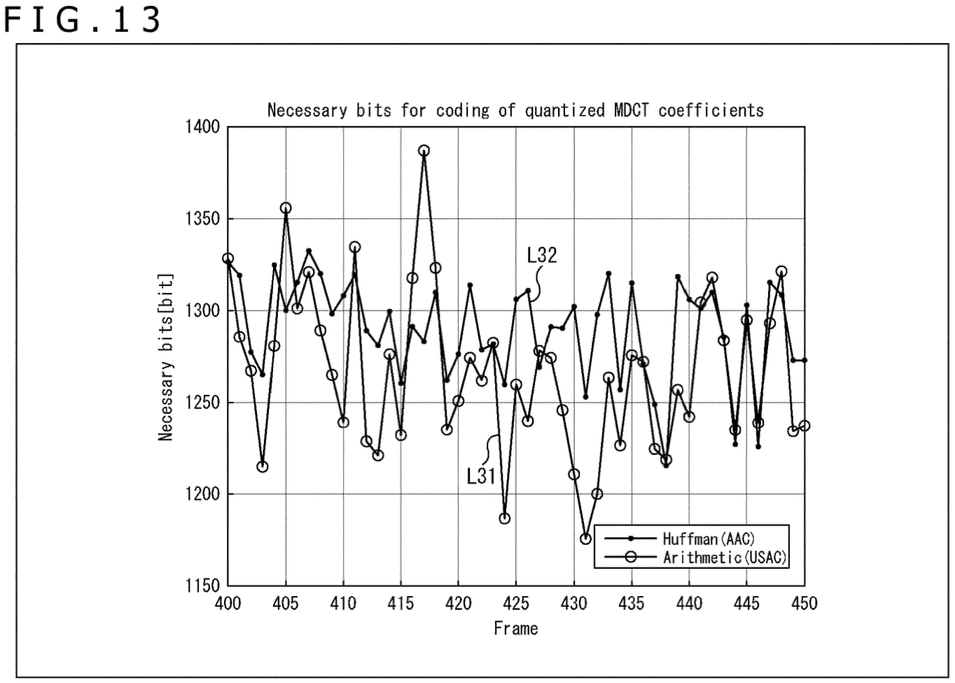

   FIG. 13 is an explanatory diagram of coding efficiencies of Huffman coding and arithmetic coding.
[FIG. 14]

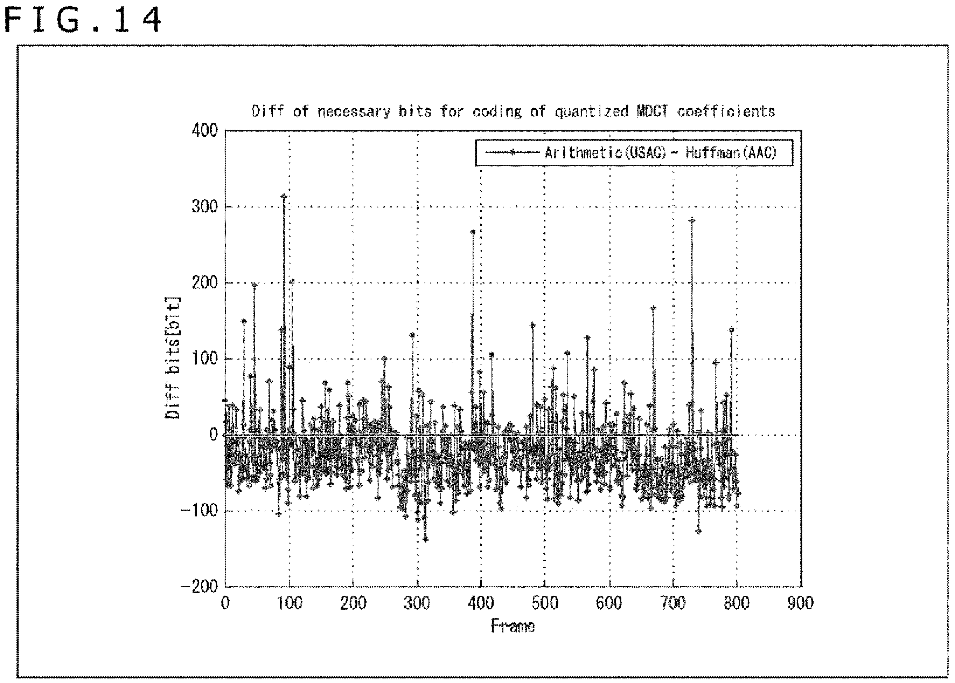

   FIG. 14 is an explanatory diagram of coding efficiencies of Huffman coding and arithmetic coding.
[FIG. 15]

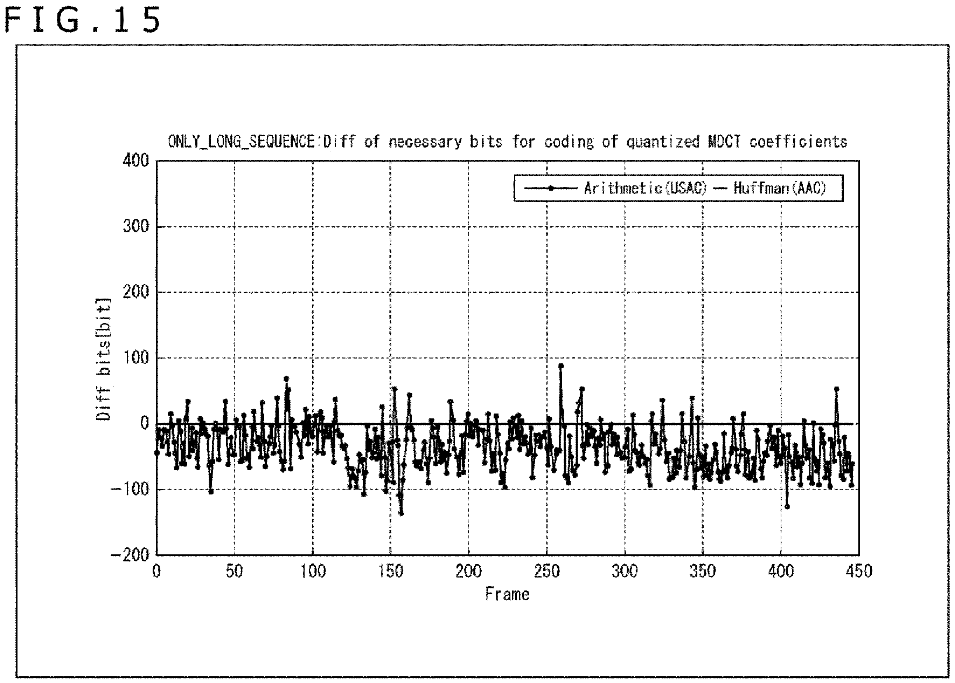

   FIG. 15 is an explanatory diagram of coding efficiencies of Huffman coding and arithmetic coding.
[FIG. 16]

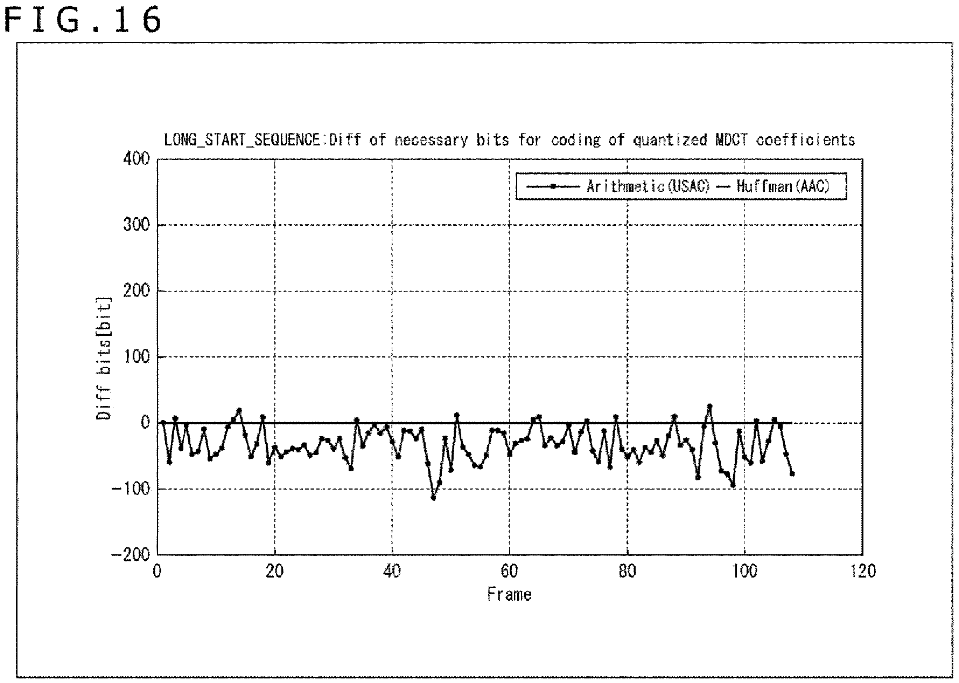

   FIG. 16 is an explanatory diagram of coding efficiencies of Huffman coding and arithmetic coding.
[FIG. 17]

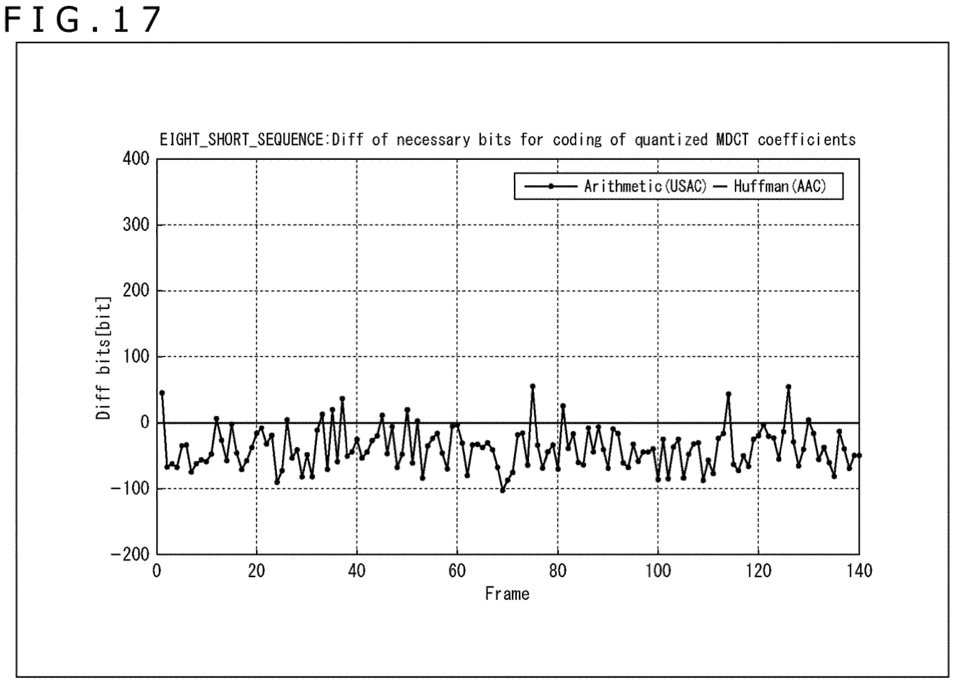

   FIG. 17 is an explanatory diagram of coding efficiencies of Huffman coding and arithmetic coding.
[FIG. 18]

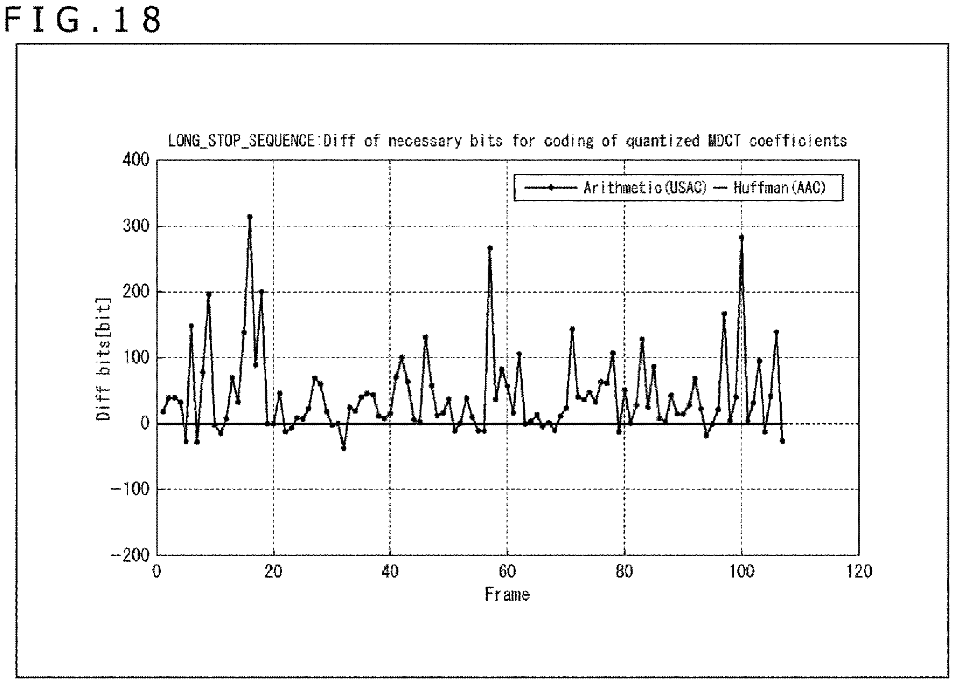

   FIG. 18 is an explanatory diagram of coding efficiencies of Huffman coding and arithmetic coding.
[FIG. 19]

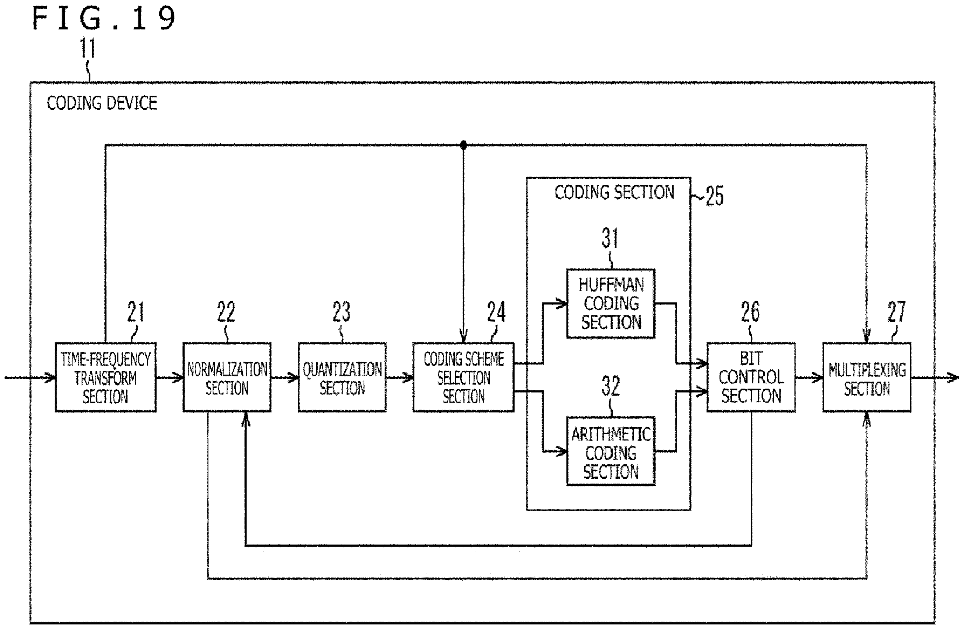

   FIG. 19 is a diagram depicting an example of a configuration of a coding device.
[FIG. 20]

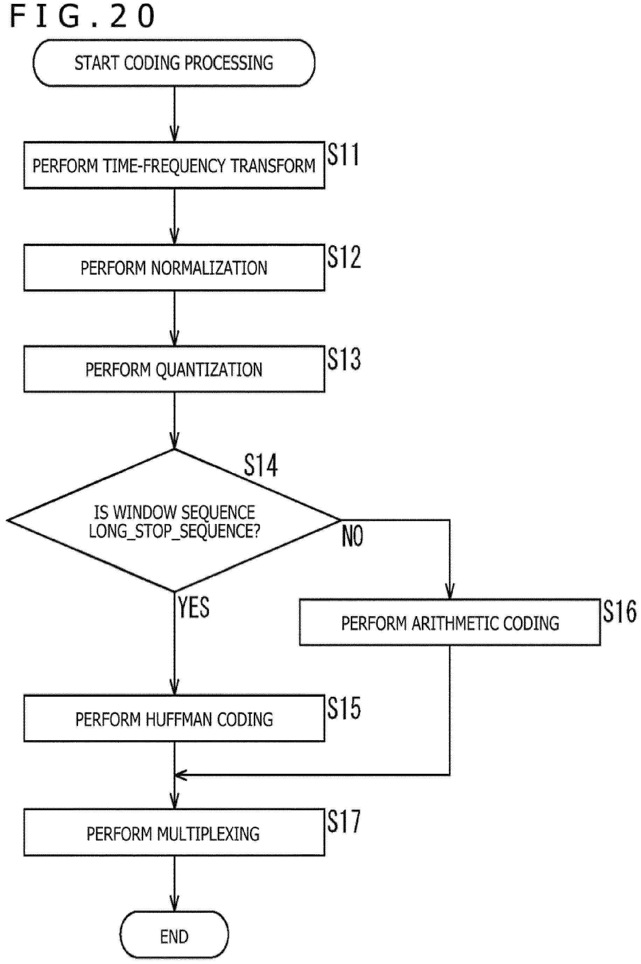

   FIG. 20 is a flowchart illustrating coding processing.
[FIG. 21]

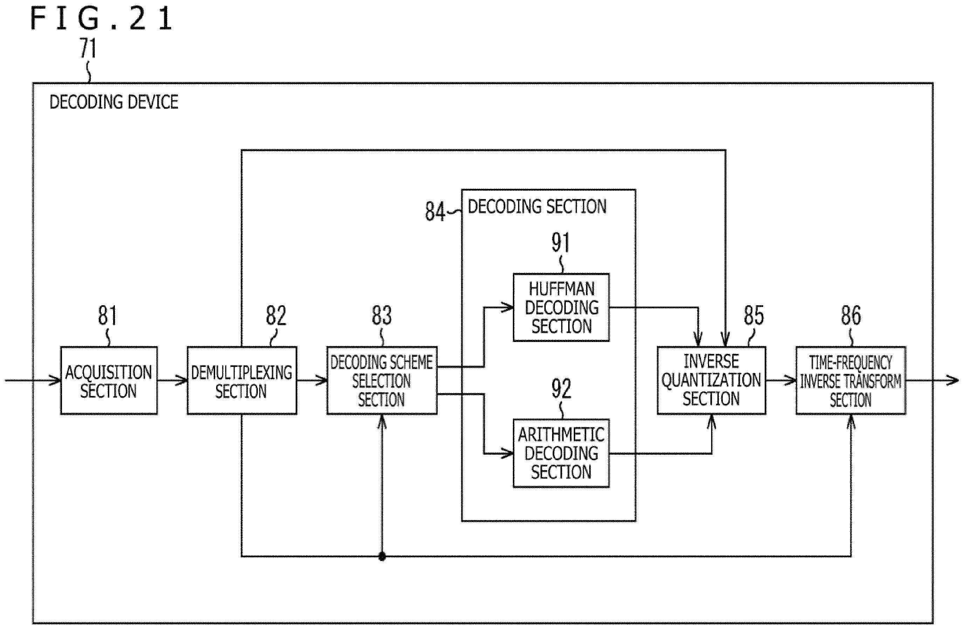

   FIG. 21 is a diagram depicting an example of a configuration of a decoding device.
[FIG. 22]

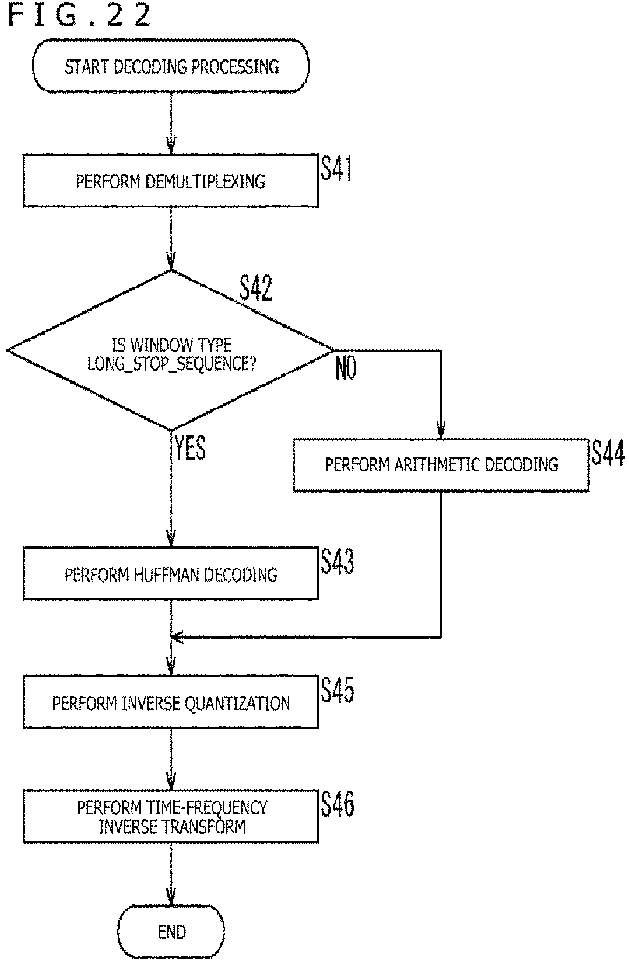

   FIG. 22 is a flowchart illustrating decoding processing.
[FIG. 23]

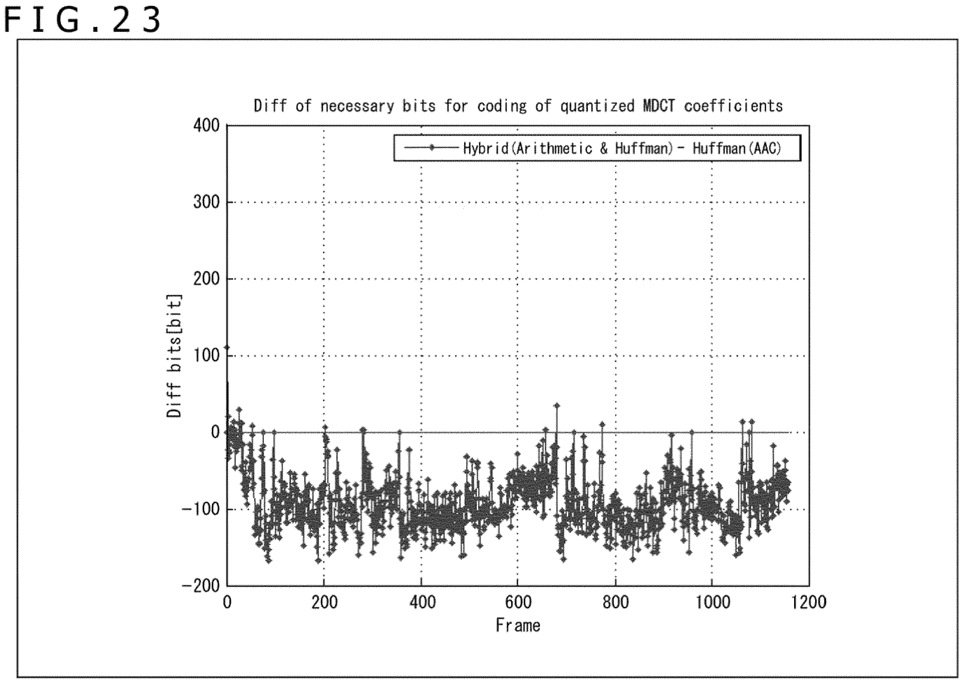

   FIG. 23 is an explanatory diagram of coding efficiencies according to the present technology.
[FIG. 24]

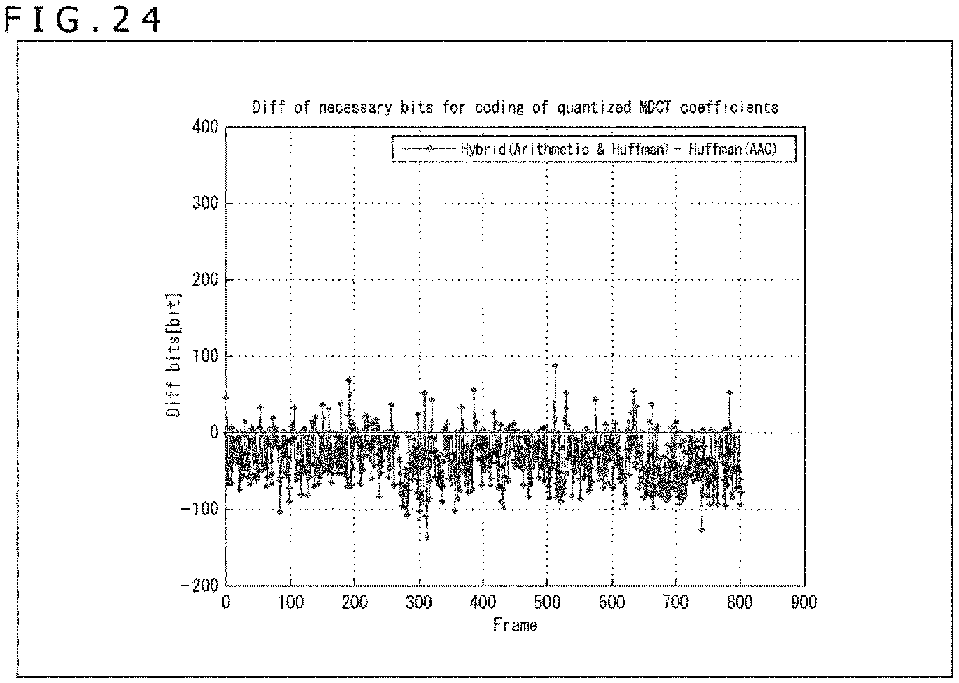

   FIG. 24 is an explanatory diagram of coding efficiencies according to the present technology.
[FIG. 25]

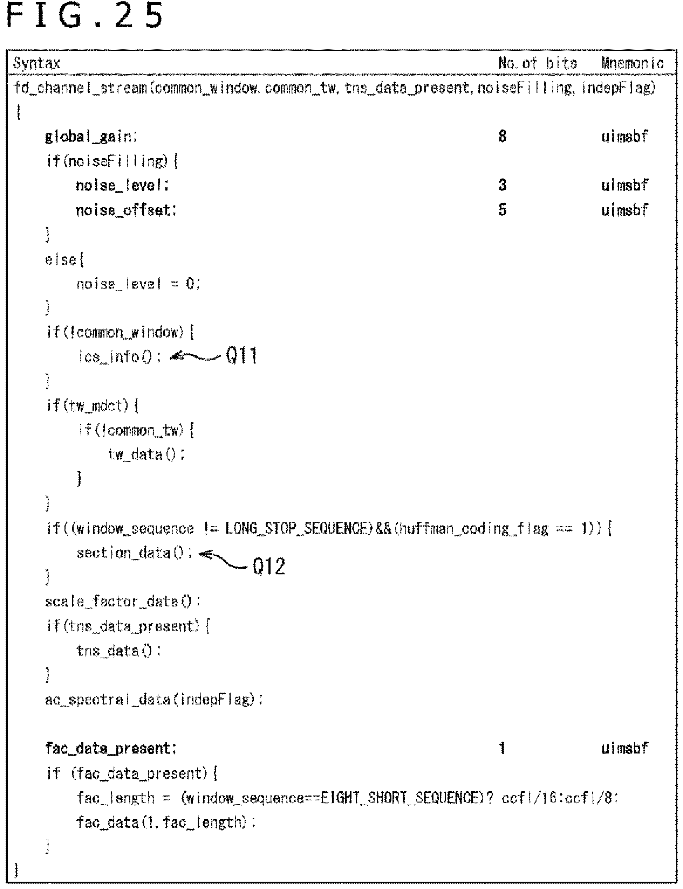

   FIG. 25 is a diagram depicting an example of syntax of a channel stream.
[FIG. 26]
   FIG. 26 is a diagram depicting an example of syntax of ics info.
[FIG. 27] FIG. 27 is a flowchart illustrating coding processing.
[FIG. 28]

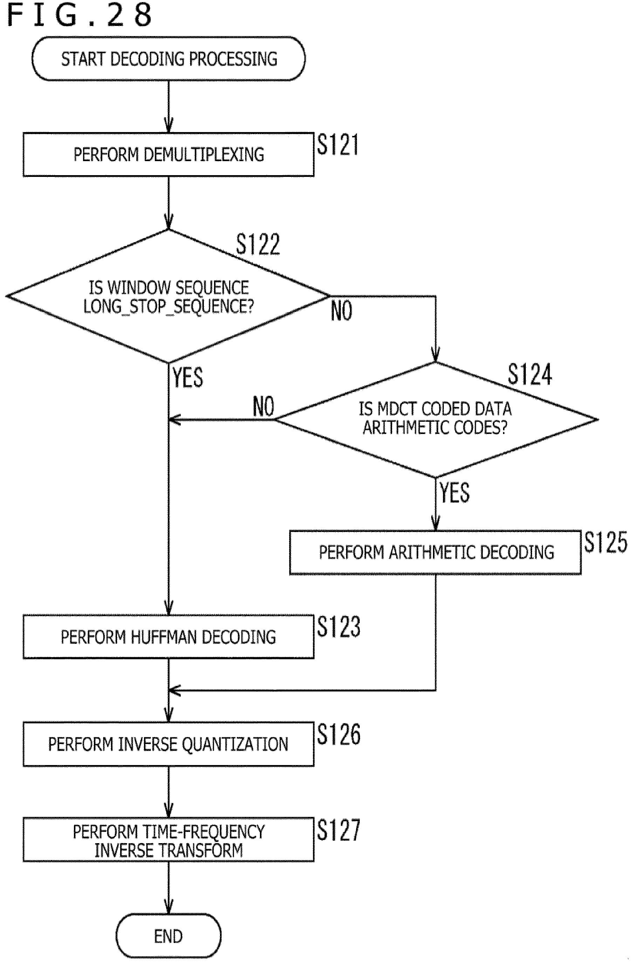

   FIG. 28 is a flowchart illustrating decoding processing.
[FIG. 29]

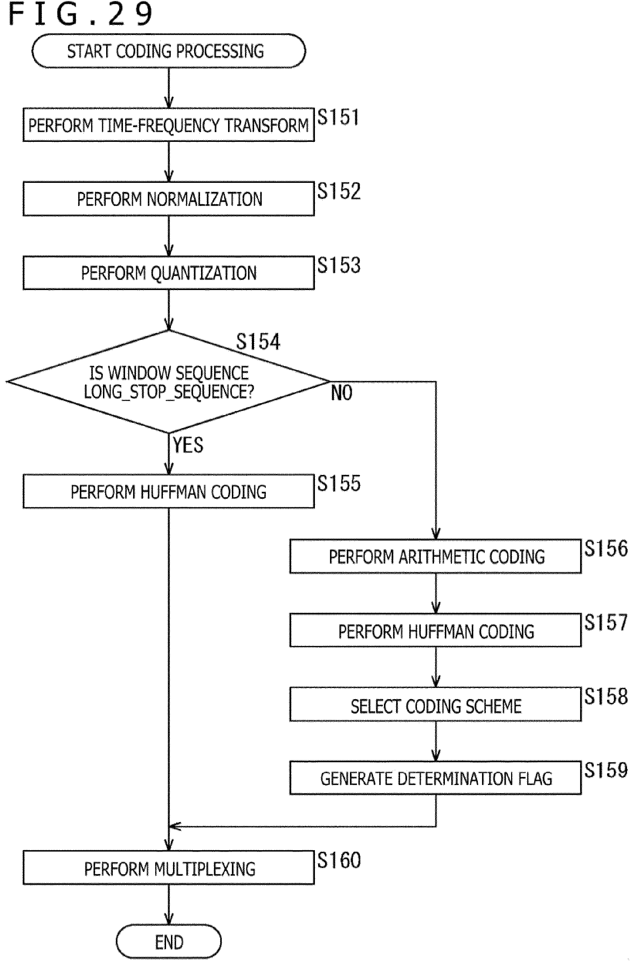

   FIG. 29 is a flowchart illustrating coding processing.
[FIG. 30]

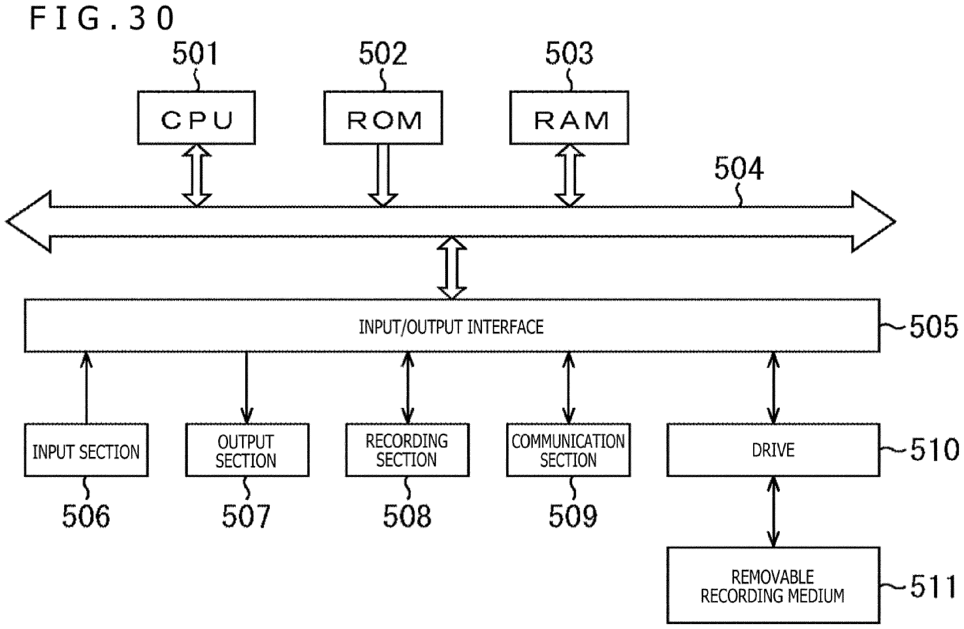

   FIG. 30 is a diagram depicting an example of a configuration of a computer.

### [Description of Embodiments]

Embodiments to which the present technology is applied will be described hereinafter with reference to the drawings.

### <First Embodiment>

### <Present Technology>

An outline of the present technology will first be described. While a signal to be coded may be any types of signal such as an audio signal and an image signal, the present technology will be described hereinafter by taking, by way of example, a case in which an object to be coded is an audio signal.

For example, in MPEG-4AAC, an audio signal is coded as depicted in FIG. 1.

In other words, when coding (encoding) processing is started, time-frequency transform is performed first on the audio signal using MDCT (Modified Discrete Cosine Transform).

Next, an MDCT coefficient that is frequency spectrum information obtained by the MDCT is quantized per scale factor band, and quantized MDCT coefficients are obtained as a result of quantization.

The scale factor band means herein a band obtained by combining a plurality of sub-bands having a predetermined bandwidth that is a resolving power of a QMF (Quadrature Mirror Filter) analysis filter.

When the quantized MDCT coefficients are obtained by quantization, Huffman coding is used for every section in which the same Huffman code book is used to code the quantized MDCT coefficients and Huffman code book information. In other words, Huffman coding is performed. It is noted that a section is a band obtained by combining a plurality of scale factor bands.

Huffman codes, that is, Huffman-coded quantized MDCT coefficients and Huffman code book information obtained as described above are output as coded data regarding the audio signal.

Furthermore, it is known that, in the time-frequency transform, selecting a suitable transform window according to a property of the audio signal normally to be processed enables compression of the audio signal at a higher sound quality than that using a single transform window.

For example, it is known that a transform window having a small transform window length is suited for a music signal having a strong attack property accompanying a sudden temporal change (attack music signal), and that a transform window having a large transform window length is suited for a music signal having a strong stationary property not accompanying a sudden temporal change (stationary music signal).

Specifically, in MPEG4 AAC, for example, the MDCT is performed while appropriately changing over to a suitable window sequence among four window sequences, as depicted in FIG. 2.

In FIG. 2, "window_sequence" indicates a window sequence. The window sequence indicates herein a type of the transform window, that is, a window type.

Particularly in MPEG4 AAC, it is possible to select one from among four types of transform windows, that is, ONLY_LONG_SEQUENCE, LONG_START_SEQUENCE, EIGHT_SHORT_SEQUENCE, and LONG_STOP_SEQUENCE as the window sequence, that is, the window type.

Moreover, in FIG. 2, "num_windows" indicates the number of transform windows used at a time of performing the MDCT using the transform window of every window type, and a shape of the transform window is illustrated in each "looks like" box. Particularly in each "looks like" box, a horizontal direction indicates a time direction in FIG. 2, and a vertical direction indicates a magnitude of the transform window at each sample position, that is, a magnitude of a coefficient by which each sample is multiplied in FIG. 2.

In MPEG4 AAC, at the time of performing the MDCT on the audio signal, ONLY_LONG_SEQUENCE is selected for a frame having a strong stationary property. The transform window indicated by this ONLY_LONG_SEQUENCE is a transform window having a transform window length of 2048 samples.

Furthermore, EIGHT_SHORT_SEQUENCE is selected for a frame having a strong attack property. The transform window indicated by this EIGHT_SHORT_SEQUENCE is eight transform windows split in the time direction, and a transform window length of each split transform window is 256 samples.

The transform window indicated by EIGHT_SHORT_SEQUENCE is smaller in the transform window length than the other transform windows such as the transform window indicated by LONG_STOP_SEQUENCE.

LONG_START_SEQUENCE is selected for a frame for which the window_sequence transitions from ONLY_LONG_SEQUENCE to EIGHT_SHORT_SEQUENCE. The transform window indicated by this LONG_START_SEQUENCE is a transform window having a transform window length of 2048 samples.

LONG_STOP_SEQUENCE is selected for a frame for which the window_sequence transitions from EIGHT_SHORT_SEQUENCE to ONLY_LONG_SEQUENCE.

In other words, in the case of changing over the transform window length of the transform window from a small transform window length to a large transform window length, LONG_STOP_SEQUENCE is selected. The transform window indicated by LONG_STOP_SEQUENCE is a transform window having a transform window length of 2048 samples.

It is noted that details of the transform windows used in MPEG4 AAC are described in, for example, "INTERNATIONAL STANDARD ISO/IEC 14496-3 Fourth edition 2009-09-01 Information technology-coding of audio-visual objects-part3:Audio" in detail.

On the other hand, in MPEG-D USAC, an audio signal is coded as depicted in FIG. 3.

In other words, when coding (encoding) processing is started, time-frequency transform is performed first on the audio signal using the MDCT similarly to the case of MPEG-4 AAC.

An MDCT coefficient obtained by the time-frequency transform is then quantized per scale factor band, and quantized MDCT coefficients are obtained as a result of quantization.

Moreover, context based arithmetic coding is performed on the quantized MDCT coefficients, and arithmetically-coded quantized MDCT coefficients are output as coded data regarding the audio signal.

In the context based arithmetic coding, a plurality of appearance probability tables in each of which a short code is allocated to an input bit sequence at a high appearance probability and a long code is allocated to an input bit sequence at a low appearance probability is prepared.

Furthermore, the efficient appearance probability table is selected on the basis of a coding result (context) of previous quantized MDCT coefficients in time and frequency proximity to the quantized MDCT coefficients to be coded. In other words, the appearance probability table is appropriately changed over in consideration of correlation of the quantized MDCT coefficients in proximity in time and frequency. In addition, the quantized MDCT coefficients are coded, using the selected appearance probability table.

In the context based arithmetic coding, performing coding by selecting the efficient appearance probability table from among the plurality of appearance probability tables makes it possible to realize high coding efficiency.

Moreover, unlike the Huffman coding, it is unnecessary to transmit code book information in the arithmetic coding. Owing to this, it is possible to reduce a code amount corresponding to the code book information in the arithmetic coding, compared with the Huffman coding.

It is noted that, in MPEG-D USAC, the MDCT is performed while appropriately changing over to a suitable window sequence among five window sequences as depicted in FIG. 4.

In FIG. 4, "Window" indicates a window sequence, "num_windows" indicates the number of transform windows used at the time of performing the MDCT using the transform window of every window type, and a shape of the transform window is illustrated in each "Window Shape" box.

In MPEG-D USAC, it is possible to select one from among five types of transform windows, that is, ONLY_LONG_SEQUENCE, LONG_START_SEQUENCE, EIGHT_SHORT_SEQUENCE, LONG_STOP_SEQUENCE, and STOP_START_SEQUENCE as the window sequence.

In particular, among the window_sequences, that is, among the window types, ONLY_LONG_SEQUENCE, LONG_START_SEQUENCE, EIGHT_SHORT_SEQUENCE, and LONG_STOP_SEQUENCE are the same as those in the case of MPEG4 AAC.

In MPEG-D USAC, STOP_START_SEQUENCE is further prepared in addition to these four window types.

STOP_START_SEQUENCE is selected for a frame for which the window_sequence transitions from LONG_STOP_SEQUENCE to LONG_START_SEQUENCE.

The transform window indicated by this STOP_START_SEQUENCE is a transform window having a transform window length of 2048 samples.

It is noted that details of MPEG-D USAC are described in, for example, "INTERNATIONAL STANDARD ISO/IEC 23003-3 Frist edition 2012-04-01 Information technology-coding of audio-visual objects-part3: Unified speech and audio coding."

It is also noted that MPEG4 AAC will be simply referred to as "AAC" and that MPEG-D USAC will be simply referred to as "USAC."

Comparison of AAC with USAC described above indicates that the context based arithmetic coding considered to be higher in the compression efficiency (coding efficiency) than the Huffman coding adopted in AAC is adopted in current USAC.

However, the context based arithmetic coding is not always greater (higher) in the compression efficiency than the Huffman coding for all audio signals.

In the USAC context based arithmetic coding, codes are shorter and the coding efficiency tends to be higher than that in the AAC Huffman coding for a stationary music signal; however, codes become longer, and the coding efficiency tends to be lower for an attack music signal.

FIGS. 5 to 18 depict such examples. It is noted that, in FIGS. 5 to 18, a horizontal axis indicates time, that is, frames of an audio signal, and that a vertical axis indicates the number of coded bits (number of necessary bits) or a difference in the number of necessary bits (the number of different bits) at a time of coding the audio signal. One frame contains, in particular, 1024 samples herein.

FIG. 5 depicts the number of necessary bits necessary in a case of performing MDCT and quantization on a stationary music signal that serves as an audio signal and performing AAC Huffman coding on the quantized MDCT coefficients after quantization, and the number of necessary bits in a case of performing USAC arithmetic coding on the same quantized MDCT coefficients after quantization.

In this example, a broken line L11 indicates the number of necessary bits in the USAC arithmetic coding in each frame, while a broken line L12 indicates the number of necessary bits in the AAC Huffman coding in each frame. In this example, it is understood that the USAC arithmetic coding is smaller in the number of necessary bits than the AAC Huffman coding in most of the frames.

Furthermore, FIG. 6 depicts a partially enlarged view of FIG. 5. It is noted that parts in FIG. 6 corresponding to those in FIG. 5 are denoted by the same reference characters and description thereof will be omitted.

It is clear from the parts depicted in FIG. 6 that a difference in the number of necessary bits between the AAC Huffman coding and the USAC arithmetic coding is approximately 100 to 150 bits, and that the USAC arithmetic coding is greater (higher) in the coding efficiency than the AAC Huffman coding.

FIG. 7 depicts the difference between the number of necessary bits in the AAC Huffman coding and the number of necessary bits in the USAC arithmetic coding, that is, the number of different bits in each frame depicted in FIG. 5.

In FIG. 7, a horizontal axis indicates a frame (time), and a vertical axis indicates the number of different bits. It is noted that the number of different bits is obtained herein by subtracting the number of necessary bits in the AAC Huffman coding from the number of necessary bits in the USAC arithmetic coding.

As clear from FIG. 7, the numbers of different bits take on negative values in most of the frames in a case in which the audio signal is the stationary music signal, that is, the audio signal has a stationary property. In other words, it is understood that the USAC arithmetic coding is smaller in the number of necessary bits than the AAC Huffman coding in most of the frames.

In a case in which the audio signal to be coded is a stationary signal, therefore, selecting the arithmetic coding as the coding scheme makes it possible to obtain a higher coding efficiency.

Moreover, during the MDCT, the window sequence, that is, the type of window sequence is selected in each frame. When a graph of the number of different bits depicted in FIG. 7 is separated into four graphs according to the four window sequences depicted in FIG. 2, the four graphs are those depicted in FIGS. 8 to 11.

In other words, FIG. 8 indicates the number of different bits in each frame for which ONLY_LONG_SEQUENCE is selected as the window sequence among the numbers of different bits in the frames depicted in FIG. 7.

Likewise, FIG. 9 depicts the number of different bits in each frame for which LONG_START_SEQUENCE is selected as the window sequence among the numbers of different bits in the frames depicted in FIG. 7. FIG. 10 depicts the number of different bits in each frame for which EIGHT_SHORT_SEQUENCE is selected as the window sequence among the numbers of different bits in the frames depicted in FIG. 7.

Furthermore, FIG. 11 depicts the number of different bits in each frame for which LONG_STOP_SEQUENCE is selected as the window sequence among the numbers of different bits in the frames depicted in FIG. 7.

It is noted that horizontal axes each indicate a frame (time) and vertical axes each indicate the number of different bits in FIGS. 8 to 11.

As clear from FIGS. 8 to 11, ONLY_LONG_SEQUENCE is selected in most of the frames since the audio signal is the stationary music signal. In addition, it is clear that there are fewer frames for which the remaining LONG_START_SEQUENCE, EIGHT_SHORT_SEQUENCE, and LONG_STOP_SEQUENCE are selected.

As depicted in FIG. 11, in a case in which LONG_STOP_SEQUENCE is selected herein, the numbers of different bits are positive values; thus, the AAC Huffman coding is higher in the coding efficiency in more frames. Nevertheless, as depicted in FIG. 7, it is understood that the USAC arithmetic coding is higher in the coding efficiency than the AAC Huffman coding as a whole.

On the other hand, FIGS. 12 to 18 correspond to FIGS. 5 to 11, respectively, and each indicates the number of necessary bits or the number of different bits in a case in which an audio signal is an attack music signal.

In other words, FIG. 12 depicts the number of necessary bits necessary in a case of performing MDCT and quantization on an attack music signal that serves as an audio signal and performing AAC Huffman coding on the quantized MDCT coefficients after quantization, and the number of necessity bits in a case of performing USAC arithmetic coding on the same quantized MDCT coefficients after quantization.

In this example, a broken line L31 indicates the number of necessary bits in the USAC arithmetic coding in each frame, while a broken line L32 indicates the number of necessary bits in the AAC Huffman coding in each frame.

In this example, the USAC arithmetic coding is smaller in the number of necessary bits than the AAC Huffman coding in many frames. However, the number of frames for which the AAC Huffman coding is smaller in the number of necessary bits than the USAC arithmetic coding in the case of the attack music signal is larger than that in the case of the stationary music signal.

Furthermore, FIG. 13 depicts a partially enlarged view of FIG. 12. It is noted that parts in FIG. 13 corresponding to those in FIG. 12 are denoted by the same reference characters and description thereof will be omitted.

It is understood from the parts depicted in FIG. 13 that the AAC Huffman coding is smaller in the number of necessary bits than the USAC arithmetic coding in several frames.

FIG. 14 depicts the difference between the number of necessary bits in the AAC Huffman coding and the number of necessary bits in the USAC arithmetic coding, that is, the number of different bits in each frame depicted in FIG. 12.

In FIG. 14, a horizontal axis indicates a frame (time), and a vertical axis indicates the number of different bits. It is noted that the number of different bits is obtained herein by subtracting the number of necessary bits in the AAC Huffman coding from the number of necessary bits in the USAC arithmetic coding.

As clear from FIG. 14, the numbers of different bits take on negative values in many frames in a case in which the audio signal is the attack music signal, that is, the audio signal has an attack property.

However, in the case in which the audio signal is the attack music signal, the number of frames for which the numbers of different bits take on positive value is large, compared with the case in which the audio signal is the stationary music signal. In other words, it is understood that the AAC Huffman coding is smaller in the number of necessary bits than the USAC arithmetic coding in more frames in the case in which the audio signal is the attack music signal.

Furthermore, during the MDCT, the window sequence, that is, the type of window sequence is selected in each frame. When a graph of the number of different bits depicted in FIG. 14 is separated into four graphs according to the four window sequences depicted in FIG. 2, the four graphs are those depicted in FIGS. 15 to 18.

In other words, FIG. 15 indicates the number of different bits in each frame for which ONLY_LONG_SEQUENCE is selected as the window sequence among the numbers of different bits in the frames depicted in FIG. 14.

Likewise, FIG. 16 depicts the number of different bits in each frame for which LONG_START_SEQUENCE is selected as the window sequence among the numbers of different bits in the frames depicted in FIG. 14. FIG. 17 depicts the number of different bits in each frame for which EIGHT_SHORT_SEQUENCE is selected as the window sequence among the numbers of different bits in the frames depicted in FIG. 14.

Furthermore, FIG. 18 depicts the number of different bits in each frame for which LONG_STOP_SEQUENCE is selected as the window sequence among the numbers of different bits in the frames depicted in FIG. 14.

It is noted that horizontal axes each indicate a frame (time) and vertical axes each indicate the number of different bits in FIGS. 15 to 18.

As clear from FIGS. 15 to 18, a proportion at which EIGHT_SHORT_SEQUENCE, LONG_START_SEQUENCE, or LONG_STOP_SEQUENCE is selected as the window sequence in the case in which the audio signal is the attack music signal is higher than that in the case in which the audio signal is the stationary music signal.

Furthermore, it is understood that, in a case in which ONLY_LONG_SEQUENCE, LONG_START_SEQUENCE, or EIGHT_SHORT_SEQUENCE is selected even if the audio signal is the attack music signal, the USAC arithmetic coding is higher in the coding efficiency than the AAC Huffman coding in most of the frames, similarly to the case of the stationary music signal.

However, it is understood that, in a case in which LONG_STOP_SEQUENCE is selected, the AAC Huffman coding is smaller in the number of necessary bits and higher in the coding efficiency than the USAC arithmetic coding in most of the frames.

This is because context correlation lowers in the USAC arithmetic coding due to transition between the frame having a strong attack property and the frame having a strong stationary property and an inefficient appearance probability table is selected.

It is noted that the number of necessary bits (code amount) in the USAC arithmetic coding is not large in the frames for each of which EIGHT_SHORT_SEQUENCE is selected because the transform windows split into eight in the time direction are used for coding the quantized MDCT coefficients. In other words, coding of the quantized MDCT coefficients is performed eight times separately to correspond to the eight split transform windows in the time direction each having the transform window length of the 256 samples; thus, a degree of a reduction in the context correlation is dispersed and mitigated.

As described above, in the case in which the audio signal has the attack property, the USAC arithmetic coding is lower in the coding efficiency (compression efficiency) than the AAC Huffman coding particularly in the frame at the time of transition from the frame using the transform window having the small transform window length to the frame using the transform window having the large transform window length, that is, in each frame for which LONG_STOP_SEQUENCE is selected.

Moreover, an increase in a code length of arithmetic codes naturally leads to an increase in computational complexity at a time of decoding.

Furthermore, the arithmetic coding has properties that it is impossible to perform decoding without making all of signs of one quantized MDCT coefficient uniform and more computational complexity than that of the Huffman coding is required due to occurrence of a large volume of computing processing per bit.

To address the problems, therefore, the present technology is intended to be capable of improving the coding efficiency and reducing computational complexity during decoding by appropriately selecting the coding scheme at the time of coding the audio signal.

Specifically, in, for example, codec using the time-frequency transform similarly to USAC, quantized frequency spectrum information is subjected to the Huffman coding in a case of transition from a frame on which the time-frequency transform is performed using a transform window having a small transform window length to a frame on which the time-frequency transform is performed using a transform window having a larger transform window length than that of the former frame.

For example, in the case of USAC, the Huffman coding is selected as the coding scheme in each frame for which LONG_STOP_SEQUENCE is selected.

Furthermore, either the Huffman coding or the arithmetic coding is selected as the coding scheme for the other frames, that is, frames other than each frame at the time of transition from the small transform window length to the large transform window length.

At this time, containing a determination flag for identifying the selected coding scheme in a coded bit stream as needed enables a decoding side to identify the selected coding scheme. In other words, specifying changeover of the determination flag or the decoding scheme in a decoder syntax enables the decoding side to appropriately change over the decoding scheme.

### <Example of Configuration of Coding Device>

Subsequently, specific embodiments of a coding device and a decoding device to which the present technology is applied will be described. It is noted that the embodiments for performing MPEG-D USAC-based coding and decoding will be described hereinafter. However, any other codec may be performed as long as coding is performed on the time-frequency transformed information by changing over the transform window length as appropriate and selecting any of a plurality of coding schemes including the context based arithmetic coding.

FIG. 19 is a diagram depicting an example of a configuration of a coding device to which the present technology is applied.

A coding device 11 depicted in FIG. 19 has a time-frequency transform section 21, a normalization section 22, a quantization section 23, a coding scheme selection section 24, a coding section 25, a bit control section 26, and a multiplexing section 27.

The time-frequency transform section 21 selects a transform window for every frame of a supplied audio signal and performs time-frequency transform on the audio signal, using the selected transform window.

In addition, the time-frequency transform section 21 supplies frequency spectrum information obtained by the time-frequency transform to the normalization section 22 and supplies transform window information indicating the type (window sequence) of the transform window selected for each frame to the coding scheme selection section 24 and the multiplexing section 27.

For example, the time-frequency transform section 21 performs MDCT as the time-frequency transform and obtains an MDCT coefficient as the frequency spectrum information. Description will be continued while taking a case in which the frequency spectrum information is the MDCT coefficient by way of example.

The normalization section 22 normalizes the MDCT coefficient supplied from the time-frequency transform section 21 on the basis of parameters for normalization supplied from the bit control section 26, supplies the normalized MDCT coefficient obtained as a result of normalization to the quantization section 23, and supplies the parameters associated with the normalization to the multiplexing section 27.

The quantization section 23 quantizes the normalized MDCT coefficient supplied from the normalization section 22 and supplies quantized MDCT coefficients obtained as a result of quantization to the coding scheme selection section 24.

The coding scheme selection section 24 selects a coding scheme on the basis of the transform window information supplied from the time-frequency transform section 21 and supplies the quantized MDCT coefficients supplied from the quantization section 23 to a block in the coding section 25 according to a selection result of the coding scheme.

The coding section 25 codes the quantized MDCT coefficients supplied from the coding scheme selection section 24 by the coding scheme selected (designated) by the coding scheme selection section 24. The coding section 25 has a Huffman coding section 31 and an arithmetic coding section 32.

The Huffman coding section 31 codes the quantized MDCT coefficients by a Huffman coding scheme in a case in which the quantized MDCT coefficients are supplied from the coding scheme selection section 24. In other words, the quantized MDCT coefficients are subjected to Huffman coding.

The Huffman coding section 31 supplies MDCT coded data obtained by the Huffman coding and Huffman code book information to the bit control section 26. The Huffman code book information means herein information indicating a Huffman code book used at the time of the Huffman coding. Furthermore, the Huffman code book information supplied to the bit control section 26 is subjected to Huffman coding.

The arithmetic coding section 32 codes the quantized MDCT coefficients by an arithmetic coding scheme in a case in which the quantized MDCT coefficients are supplied from the coding scheme selection section 24. In other words, the quantized MDCT coefficients are subjected to context based arithmetic coding.

The arithmetic coding section 32 supplies MDCT coded data obtained by the arithmetic coding to the bit control section 26.

The bit control section 26 determines a bit amount and a sound quality when the MDCT coded data and the Huffman code book information are supplied from the Huffman coding section 31 to the bit control section 26 or when the MDCT coded data is supplied from the arithmetic coding section 32 to the bit control section 26.

In other words, the bit control section 26 determines whether the bit amount (code amount) of the MDCT coded data and/or the like is within a target to-be-used bit amount and determines whether the sound quality of a sound based on the MDCT coded data is a quality within an allowable range.

The bit control section 26 supplies the supplied MDCT coded data and/or the like to the multiplexing section 27 in a case in which the bit amount of the MDCT coded data and/or the like is within the target to-be-used bit amount and the sound quality is within the allowable range.

Conversely, the bit control section 26 resets the parameters to be supplied to the normalization section 22, and supplies the reset parameters to the normalization section 22 to cause coding to be carried out again in a case in which the bit amount of the MDCT coded data and/or the like is not within the target to-be-used bit amount or the sound quality is not within the allowable range.

The multiplexing section 27 multiplexes the MDCT coded data and the Huffman code book information which are supplied from the bit control section 26, the transform window information supplied from the time-frequency transform section 21, and the parameters supplied from the normalization section 22 and outputs a coded bit stream obtained as a result of multiplexing.

### <Description of Coding Processing>

Operations performed by the coding device 11 will next be described. In other words, coding processing performed by the coding device 11 will be described with reference to a flowchart of FIG. 20. It is noted that this coding processing is performed for each frame of the audio signal.

In Step S11, the time-frequency transform section 21 performs time-frequency transform on a frame of the supplied audio signal.

In other words, the time-frequency transform section 21 determines an attack property or a stationary property of the frame to be processed of the audio signal on the basis of, for example, MDCT coefficients in proximity in time and frequency to the MDCT coefficients or a magnitude and a variation amount of the audio signal. In other words, the time-frequency transform section 21 identifies whether the audio signal has an attack property or a stationary property from a magnitude and a variation amount of the MDCT coefficients, the magnitude and the variation amount of the audio signal, and the like.

The time-frequency transform section 21 selects a transform window for the frame to be processed on the basis of a determination result of the attack property or the stationary property, a selection result of the transform window for the frame temporally immediately preceding the frame to be processed, and the like and performs time-frequency transform on the frame to be processed of the audio signal, using the selected transform window. The time-frequency transform section 21 supplies the MDCT coefficient obtained by the time-frequency transform to the normalization section 22 and supplies the transform window information indicating the type of the selected transform window to the coding scheme selection section 24 and the multiplexing section 27.

In Step S12, the normalization section 22 normalizes the MDCT coefficient supplied from the time-frequency transform section 21 on the basis of the parameters supplied from the bit control section 26, supplies the normalized MDCT coefficient obtained as a result of normalization to the quantization section 23 and supplies the parameters associated with the normalization to the multiplexing section 27.

In Step S13, the quantization section 23 quantizes the normalized MDCT coefficient supplied from the normalization section 22 and supplies the quantized MDCT coefficients obtained as a result of quantization to the coding scheme selection section 24.

In Step S14, the coding scheme selection section 24 determines whether or not the type of the transform window, that is, the window sequence indicated by the transform window information supplied from the time-frequency transform section 21 is LONG_STOP_SEQUENCE.

In a case of determining in Step S14 that the window sequence is LONG_STOP_SEQUENCE, the coding scheme selection section 24 supplies the quantized MDCT coefficients supplied from the quantization section 23 to the Huffman coding section 31, and the processing then goes to Step S15.

The frame for which LONG_STOP_SEQUENCE is selected is the frame at the time of transition from the frame having a strong attack property and a small transform window length, that is, EIGHT_SHORT_SEQUENCE to the frame having a strong stationary property and a large transform window length, that is, ONLY_LONG_SEQUENCE.

In a case of such a frame for which the transform window length is changed over from the small transform window length to the large transform window length, that is, the frame for which LONG_STOP_SEQUENCE is selected, the Huffman coding is higher in coding efficiency than the arithmetic coding as described with reference to, for example, FIG. 18.

Therefore, at the time of coding of such a frame, the Huffman coding scheme is selected as the coding scheme. In other words, the quantized MDCT coefficients and the Huffman code book information are coded, using Huffman codes for every section, using the same Huffman code book, similarly to MPEG4 AAC.

In Step S15, the Huffman coding section 31 performs Huffman coding on the quantized MDCT coefficients supplied from the coding scheme selection section 24, using the Huffman code book information, and supplies the MDCT coded data and the Huffman code book information to the bit control section 26.

The bit control section 26 determines the target to-be-used bit amount and the sound quality on the basis of the MDCT coded data and the Huffman code book information which are supplied from the Huffman coding section 31. The coding device 11 repeatedly performs a series of processing including parameter resetting, normalization, quantization, and Huffman coding until the MDCT coded data and the Huffman code book information at a target bit amount and a target quality are obtained.

Furthermore, when the MDCT coded data and the Huffman code book information at the target bit amount and the target quality are obtained, the bit control section 26 supplies the MDCT coded data and the Huffman code book information to the multiplexing section 27, and the processing goes to Step S17.

Conversely, in a case of determining in Step S14 that the window sequence is not LONG_STOP_SEQUENCE, that is, in a case of no changeover from the small transform window length to the large transform window length, the processing then goes to Step S16. In this case, the coding scheme selection section 24 supplies the quantized MDCT coefficients supplied from the quantization section 23 to the arithmetic coding section 32.

In Step S16, the arithmetic coding section 32 performs context based arithmetic coding on the quantized MDCT coefficients supplied from the coding scheme selection section 24 and supplies the MDCT coded data to the bit control section 26. In other words, the quantized MDCT coefficients are subjected to arithmetic coding.

The bit control section 26 determines the target to-be-used bit amount and the sound quality on the basis of the MDCT coded data supplied from the arithmetic coding section 32. The coding device 11 repeatedly performs processing including parameter resetting, normalization, quantization, and arithmetic coding until the MDCT coded data at the target bit amount and the target quality is obtained.

Furthermore, when the MDCT coded data at the target bit amount and the target quality is obtained, the bit control section 26 supplies the MDCT coded data to the multiplexing section 27, and the processing goes to Step S17.

When processing of Step S15 or S16 is performed, processing of Step S17 is performed.

In other words, in Step S17, the multiplexing section 27 performs multiplexing to generate a coded bit stream and transmits (outputs) the obtained coded bit stream to a decoding device or the like.

For example, in a case in which the processing of Step S15 is performed, the multiplexing section 27 multiplexes the MDCT coded data and the Huffman code book information which are supplied from the bit control section 26, the transform window information supplied from the time-frequency transform section 21, and the parameters supplied from the normalization section 22 and generates the coded bit stream.

Furthermore, in a case, for example, in which the processing of Step S16 is performed, the multiplexing section 27 multiplexes the MDCT coded data supplied from the bit control section 26, the transform window information supplied from the time-frequency transform section 21, and the parameters supplied from the normalization section 22, and generates the coded bit stream.

When the coded bit stream obtained in this way is output, the coding processing is over.

As described so far, the coding device 11 selects the coding scheme according to the type of the transform window used at the time of the time-frequency transform. By doing so, it is possible to select a suitable coding scheme for every frame and improve coding efficiency.

### <Example of Configuration of Decoding Device>

Subsequently, the decoding device which receives the coded bit stream output from the coding device 11 and performs decoding will be described.

Such a decoding device is configured as depicted in, for example, FIG. 21.

A decoding device 71 depicted in FIG. 21 has an acquisition section 81, a demultiplexing section 82, a decoding scheme selection section 83, a decoding section 84, an inverse quantization section 85, and a time-frequency inverse transform section 86.

The acquisition section 81 acquires the coded bit stream by receiving the coded bit stream supplied from the coding device 11 and supplies the coded bit stream to the demultiplexing section 82.

The demultiplexing section 82 demultiplexes the coded bit stream supplied from the acquisition section 81 and supplies the MDCT coded data and the Huffman code book information which are obtained by demultiplexing to the decoding scheme selection section 83. In addition, the demultiplexing section 82 supplies the parameters associated with normalization and obtained by demultiplexing to the inverse quantization section 85 and supplies the transform window information obtained by demultiplexing to the decoding scheme selection section 83 and the time-frequency inverse transform section 86.

The decoding scheme selection section 83 selects a decoding scheme on the basis of the transform window information supplied from the demultiplexing section 82, and supplies the MDCT coded data and the like supplied from the demultiplexing section 82 to a block in the decoding section 84 according to a selection result of the decoding scheme.

The decoding section 84 decodes the MDCT coded data and the like supplied from the decoding scheme selection section 83. The decoding section 84 has a Huffman decoding section 91 and an arithmetic decoding section 92.

The Huffman decoding section 91 decodes the MDCT coded data by the decoding scheme corresponding to the Huffman coding, using the Huffman code book information, and supplies the quantized MDCT coefficients obtained as a result of decoding to the inverse quantization section 85 in a case in which the MDCT coded data and the Huffman code book information are supplied from the decoding scheme selection section 83.

The arithmetic decoding section 92 decodes the MDCT coded data by the decoding scheme corresponding to the arithmetic coding and supplies the quantized MDCT coefficients obtained as a result of decoding to the inverse quantization section 85 in a case in which the MDCT coded data is supplied from the decoding scheme selection section 83.

The inverse quantization section 85 inversely quantizes the quantized MDCT coefficients supplied from the Huffman decoding section 91 or the arithmetic decoding section 92, using the parameters supplied from the demultiplexing section 82, and supplies the MDCT coefficient obtained as a result of inverse quantization to the time-frequency inverse transform section 86. More specifically, the inverse quantization section 85 obtains the MDCT coefficient by, for example, multiplying a value obtained by inversely quantizing the quantized MDCT coefficients by the parameters or the like supplied from the demultiplexing section 82.

The time-frequency inverse transform section 86 performs time-frequency inverse transform on the MDCT coefficient supplied from the inverse quantization section 85 on the basis of the transform window information supplied from the demultiplexing section 82 and outputs an output audio signal that is a time signal obtained as a result of time-frequency inverse transform to a later stage.

### <Description of Decoding Processing>

Operations performed by the decoding device 71 will next be described. In other words, decoding processing performed by the decoding device 71 will be described with reference to a flowchart of FIG. 22. It is noted that this decoding processing is started when the acquisition section 81 receives a coded bit stream corresponding to one frame.

In Step S41, the demultiplexing section 82 demultiplexes the coded bit stream supplied from the acquisition section 81 and supplies the MDCT coded data and the like obtained by demultiplexing to the decoding scheme selection section 83 and the like. In other words, the MDCT coded data, the transform window information, and various kinds of parameters are extracted from the coded bit stream.

In this case, when the audio signal (MDCT coefficient) is subjected to Huffman coding, the MDCT coded data and the Huffman code book information are extracted from the coded bit stream. In contrast, when the audio signal is subjected to arithmetic coding, the MDCT coded data is extracted from the coded bit stream.

Furthermore, the demultiplexing section 82 supplies the parameters associated with normalization and obtained by demultiplexing to the inverse quantization section 85, and supplies the transform window information obtained by demultiplexing to the decoding scheme selection section 83 and the time-frequency inverse transform section 86.

In Step S42, the decoding scheme selection section 83 determines whether or not the type of the transform window indicated by the transform window information supplied from the demultiplexing section 82 is LONG_STOP_SEQUENCE.

In a case of determining in Step S42 that the type of the transform window is LONG_STOP_SEQUENCE, the decoding scheme selection section 83 supplies the MDCT coded data and the Huffman code book information which are supplied from the demultiplexing section 82 to the Huffman decoding section 91, and the processing goes to Step S43.

In this case, the frame to be processed is the frame at the time of changing over from the frame having the small transform window length to the frame having the large transform window length. In other words, the transform window indicated by the transform window information is the transform window selected at the time of changing over from the small transform window length to the large transform window length. Owing to this, the decoding scheme selection section 83 selects the decoding scheme corresponding to the Huffman coding as the decoding scheme.

In Step S43, the Huffman decoding section 91 decodes the MDCT coded data and the Huffman code book information which are supplied from the decoding scheme selection section 83, that is, Huffman codes. Specifically, the Huffman decoding section 91 obtains the quantized MDCT coefficients on the basis of the Huffman code book information and the MDCT coded data.

The Huffman decoding section 91 supplies the quantized MDCT coefficients obtained by decoding to the inverse quantization section 85, and the processing then goes to Step S45.

Conversely, in a case of determining in Step S42 that the type of the transform window is not LONG_STOP_SEQUENCE, the decoding scheme selection section 83 supplies the MDCT coded data supplied from the demultiplexing section 82 to the arithmetic decoding section 92, and the processing goes to Step S44.

In this case, the frame to be processed is not the frame at the time of changing over from the frame having the small transform window length to the frame having the large transform window length. In other words, the transform window indicated by the transform window information is not the transform window selected at the time of changing over from the small transform window length to the large transform window length. Owing to this, the decoding scheme selection section 83 selects the decoding scheme corresponding to the arithmetic coding as the decoding scheme.

In Step S44, the arithmetic decoding section 92 decodes the MDCT coded data supplied from the decoding scheme selection section 83, that is, arithmetic codes.

The arithmetic decoding section 92 supplies the quantized MDCT coefficients obtained by decoding the MDCT coded data to the inverse quantization section 85, and the processing then goes to Step S45.

When processing of Step S43 or S44 is performed, processing of Step S45 is performed.

In Step S45, the inverse quantization section 85 inversely quantizes the quantized MDCT coefficients supplied from the Huffman decoding section 91 or the arithmetic decoding section 92, using the parameters supplied from the demultiplexing section 82 and supplies the MDCT coefficient obtained as a result of demultiplexing to the time-frequency inverse transform section 86.

In Step S46, the time-frequency inverse transform section 86 performs time-frequency inverse transform on the MDCT coefficient supplied from the inverse quantization section 85 on the basis of the transform window information supplied from the demultiplexing section 82 and outputs an output audio signal obtained as a result of time-frequency inverse transform to a later stage.

When the output audio signal is output, the decoding processing is over.

As described so far, the decoding device 71 selects the decoding scheme on the basis of the transform window information obtained by demultiplexing the coded bit stream and performs decoding by the selected decoding scheme. Particularly in the case in which the type of the transform window is LONG_STOP_SEQUENCE, the decoding scheme corresponding to the Huffman coding is selected; otherwise, the decoding scheme corresponding to the arithmetic coding is selected. By doing so, it is possible to not only improve the coding efficiency on the coding side but also reduce a throughput (computing amount) during decoding on the decoding side.

Meanwhile, an approach of performing Huffman coding on a frame for which LONG_STOP_SEQUENCE is selected and performing arithmetic coding on a frame for which the type of the transform window other than LONG_STOP_SEQUENCE is selected will be referred to as "hybrid coding approach." According to such a hybrid coding approach, it is possible to improve the coding efficiency and reduce the throughput during decoding.

For example, FIG. 23 depicts a graph of a difference in the number of necessary bits between a case of using the Huffman coding on a frame for which LONG_STOP_SEQUENCE according to USAC is selected, that is, a case of performing coding by the hybrid coding approach and a case of always using the AAC Huffman coding at the time of coding the same stationary music signal as that in the case depicted in FIG. 5.

It is noted that a horizontal axis indicates a frame (time) and a vertical axis indicates the number of different bits in FIG. 23. The number of different bits mentioned here is obtained by subtracting the number of necessary bits in the AAC Huffman coding from the number of necessary bits in the hybrid coding approach.

The number of different bits in each frame depicted in FIG. 23 corresponds to the number of different bits depicted in FIG. 7. Comparison between FIGS. 23 and 7, that is, comparison between the case of performing coding by the hybrid coding approach and the case of always performing the arithmetic coding indicates that, although the example of FIG. 23 is higher in the coding efficiency, a difference in the coding efficiency is not so great.

In contrast, FIG. 24 depicts a difference in the number of necessary bits between the case of using the Huffman coding on each frame for which LONG_STOP_SEQUENCE according to the USAC is selected, that is, the case of performing coding by the hybrid coding approach and the case of always using the AAC Huffman coding at the time of coding the same attack music signal as that in the case depicted in FIG. 12.

It is noted that a horizontal axis indicates a frame (time) and a vertical axis indicates the number of different bits in FIG. 24. The number of different bits mentioned herein is obtained by subtracting the number of necessary bits in the AAC Huffman coding from the number of necessary bits in the hybrid coding approach.

The number of different bits in each frame depicted in FIG. 24 corresponds to the number of different bits depicted in FIG. 14. Comparison between FIGS. 24 and 14, that is, comparison between the case of performing coding by the hybrid coding approach and the case of always performing the arithmetic coding indicates that the example of FIG. 24 is greatly smaller in the number of different bits. In other words, the comparison indicates that the example of FIG. 24 has a greater improvement in the coding efficiency.

Moreover, with the hybrid coding approach, using not the arithmetic coding but the Huffman coding on each frame for which LONG_STOP_SEQUENCE is selected makes it possible to also reduce the throughput during the decoding of the frame.

### <Second Embodiment>

### <Selection of Coding Scheme>

Meanwhile, it has been described so far that the arithmetic coding is always selected as the coding scheme for each frame for which the type of the transform window other than LONG_STOP_SEQUENCE is selected. However, in selecting the coding scheme, it is preferable to consider not only the coding efficiency (compression efficiency) but also an allowance of the throughput, the sound quality, and the like.

Therefore, it is also possible to select, for example, either the Huffman coding or the arithmetic coding on a frame for which the type of the transform window other than LONG_STOP_SEQUENCE is selected.

In such a case, a determination flag indicating which is selected, Huffman coding or arithmetic coding as a coding scheme during coding is stored, for example, in the coded bit stream.

It is assumed herein, for example, that a value "1" of the determination flag indicates that the Huffman coding scheme is selected and that a value "0" of the determination flag indicates that the arithmetic coding scheme is selected.

Such a determination flag may be said as selection information indicating the coding scheme selected for the frame to be processed in the case in which the frame is the frame for which the type of the transform window other than LONG_STOP_SEQUENCE is selected, that is, in the case in which the small transform window length is not changed over to the large transform window length. In other words, the determination flag may be said as the selection information indicating a selection result of the coding scheme.

It is noted that the determination flag is not contained in the coded bit stream for the frame for which LONG_STOP_SEQUENCE is selected since the Huffman coding scheme is always selected for such a frame.

For example, in a case in which the determination flag is stored in the coded bit stream as appropriate, a syntax of a channel stream corresponding to one frame of an audio signal in a predetermined channel in the coded bit stream may be an MPEG-D USAC-based syntax as depicted in FIG. 25.

In an example depicted in FIG. 25, a part denoted by an arrow Q11, that is, a part of a character "ics_info()" indicates ics_info in which information associated with the transform window and the like is stored.

In addition, a part of a character "section_data()" denoted by an arrow Q12 indicates section_data. The Huffman code book information and the like are stored in this section_data. Furthermore, a character "ac_spectral_data" in FIG. 25 indicates the MDCT coded data.

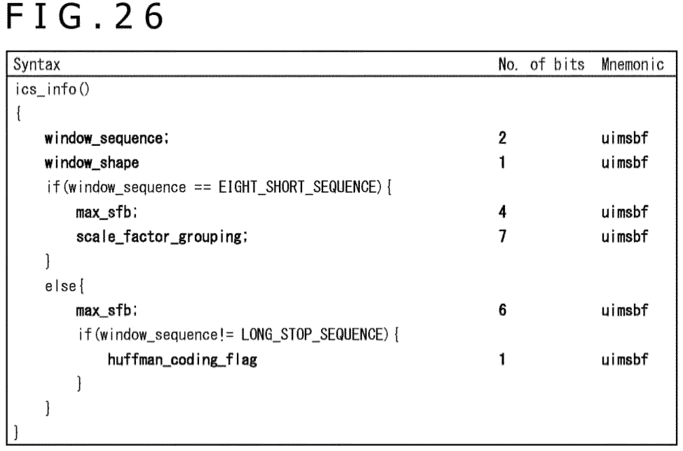

Moreover, a syntax of the part ics_info indicated by the character "ics_info()" is, for example, depicted in FIG. 26.

In an example depicted in FIG. 26, a part of a character "window_sequence" indicates the transform window information, that is, the window sequence, and a part of a character "window_shape" indicates the shape of the transform window.

Furthermore, a part of a character "huffman_coding_flag" indicates the determination flag.

In a case herein in which the transform window information stored in the part of the character "window_sequence" indicates LONG_STOP_SEQUENCE, the determination flag is not stored in the ics_info. In contrast, in a case in which the transform window information indicates the type other than LONG_STOP_SEQUENCE, the determination flag is stored in the ics_info.

In the example depicted in FIG. 25, therefore, in a case in which the transform window information stored in the part of the character "window_sequence" of FIG. 26 indicates the type other than LONG_STOP_SEQUENCE and in which the determination flag having a value "1" is stored in the part of the character "huffman_coding_flag" of FIG. 26, the Huffman code book information and the like are stored in the section_data. Furthermore, also in the case in which the transform window information stored in the part of the character "window_sequence" of FIG. 26 indicates LONG_STOP_SEQUENCE, the Huffman code book information and the like are also stored in the section_data.

### <Description of Coding Processing>

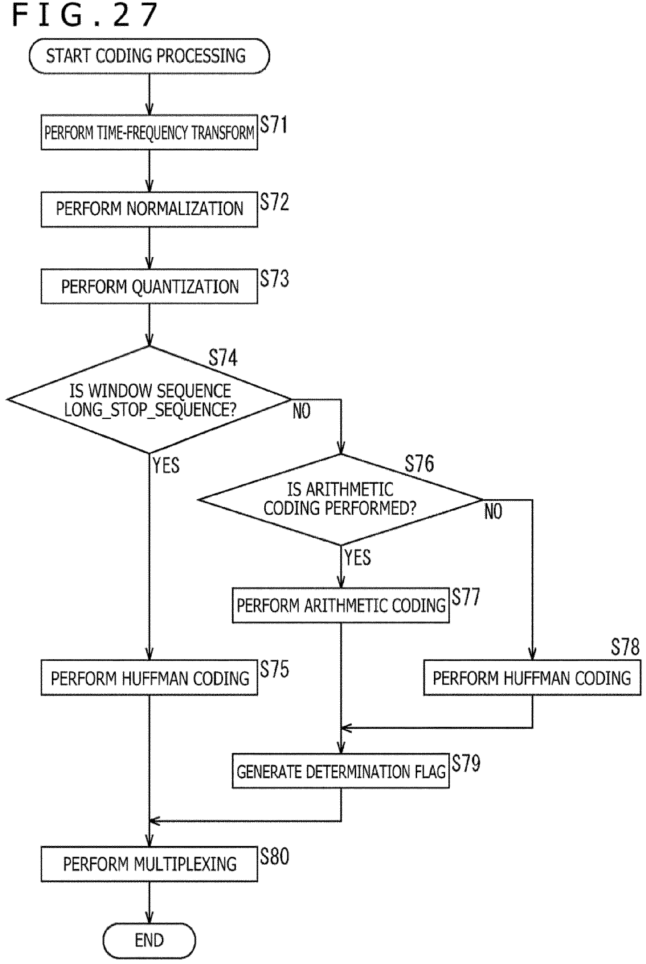

In the case in which the determination flag is stored in the coded bit stream as appropriate as in the examples depicted in FIGS. 25 and 26, the coding device 11 performs coding processing depicted in, for example, FIG. 27. The coding processing performed by the coding device 11 will be described hereinafter with reference to a flowchart of FIG. 27.

It is noted that description of processing of Steps S71 to S75 will be omitted since the processing is similar to the processing of Steps S11 to S15 of FIG. 20.

In a case of determining in Step S74 that the window sequence is not LONG_STOP_SEQUENCE, the coding scheme selection section 24 determines whether or not to perform the arithmetic coding in Step S76.

The coding scheme selection section 24 determines whether or not to perform the arithmetic coding on the basis of, for example, designation information supplied from a higher- order control device.

The designation information means herein information indicating the coding scheme designated by, for example, a content maker or the like. For example, the content maker can designate either the Huffman coding or the arithmetic coding as the coding scheme for every frame in the case of the frame for which the window sequence is not LONG_STOP_SEQUENCE.

In this case, the coding scheme selection section 24 determines to perform the arithmetic coding in Step S76 when the coding scheme indicated by the designation information is the arithmetic coding. In contrast, the coding scheme selection section 24 determines not to perform the arithmetic coding in Step S76 when the coding scheme indicated by the designation information is the Huffman coding.

Furthermore, the coding scheme selection section 24 may select the coding scheme in Step S76 on the basis of resources of the decoding device 71 and the coding device 11, that is, the throughput, a bit rate of the audio signal to be coded, whether or not a real time property is demanded, and the like.

Specifically, in a case, for example, in which the bit rate of the audio signal is high and a sufficient sound quality can be ensured, the coding scheme selection section 24 may select the Huffman coding lower in the throughput and determine not to perform the arithmetic coding in Step S76.

Moreover, in a case, for example, in which the real time property is demanded, the decoding device 71 has fewer resources and it is important to perform coding and decoding processing promptly with lower throughput preferentially over the sound quality, the coding scheme selection section 24 may select the Huffman coding and determine not to perform the arithmetic coding in Step S76.

In the case in which the real time property is demanded or the decoding side has fewer resources in this way, selecting the Huffman coding as the coding scheme makes it possible to perform processing (operations) at a higher speed than that at the time of always performing arithmetic coding.

It is noted that as for the resources of the decoding device 71, it is only sufficient to acquire a computing processing capability of an apparatus where the decoding device 71 is provided, information indicating a memory capacity, and the like, for example, from the decoding device 71 in advance before start of the coding processing or the like as resource information regarding the decoding device 71.

In a case of determining to perform the arithmetic coding in Step S76, the coding scheme selection section 24 supplies the quantized MDCT coefficients supplied from the quantization section 23 to the arithmetic coding section 32, and processing of Step S77 is then performed. In other words, in Step S77, context based arithmetic coding is performed on the quantized MDCT coefficients.

It is noted that description of processing of Step S77 will be omitted since the processing is similar to that of Step S16 of FIG. 20. When the processing of Step S77 is performed, the processing then goes to Step S79.

In contrast, in a case of determining not to perform the arithmetic coding, that is, determining to perform the Huffman coding in Step S76, the coding scheme selection section 24 supplies the quantized MDCT coefficients supplied from the quantization section 23 to the Huffman coding section 31, and the processing goes to Step S78.

In Step S78, similar processing to that of Step S75 is performed, and the MDCT coded data and the Huffman code book information which are obtained as a result of the processing are supplied from the Huffman coding section 31 to the bit control section 26. When the processing of Step S78 is performed, the processing then goes to Step S79.

When the processing of Step S77 or S78 is performed, the bit control section 26 generates a determination flag in Step S79.

In the case, for example, in which the processing of Step S77, that is, the arithmetic coding is performed, the bit control section 26 generates a determination flag having a value "0" and supplies the generated determination flag together with the MDCT coded data supplied from the arithmetic coding section 32 to the multiplexing section 27.

Furthermore, in the case, for example, in which the processing of Step S78, that is, the Huffman coding is performed, the bit control section 26 generates a determination flag having a value "1" and supplies the generated determination flag together with the MDCT coded data and the Huffman code book information which are supplied from the Huffman coding section 31 to the multiplexing section 27.

When the processing of Step S79 is performed, the processing then goes to Step S80.

When the processing of Step S75 or S79 is performed, the multiplexing section 27 performs multiplexing to generate a coded bit stream and transmits the obtained coded bit stream to the decoding device 71 in Step S80. It is noted that processing similar to that of Step S17 of FIG. 20 is basically performed in Step S80.

In the case, for example, in which the processing of Step S75 is performed, the multiplexing section 27 generates a coded bit stream storing therein the MDCT coded data, the Huffman code book information, the transform window information, and the parameters from the normalization section 22. The determination flag is not contained in this coded bit stream.

Furthermore, in the case, for example, in which the processing of Step S78 is performed, the multiplexing section 27 generates a coded bit stream storing therein the determination flag, the MDCT coded data, the Huffman code book information, the transform window information, and the parameters from the normalization section 22.

Moreover, in the case, for example, in which the processing of Step S77 is performed, the multiplexing section 27 generates a coded bit stream storing therein the determination flag, the MDCT coded data, the transform window information, and the parameters from the normalization section 22.

When the coded bit stream is generated and output in this way, the coding processing is over.

As described so far, the coding device 11 selects either the Huffman coding or the arithmetic coding for a frame for which the window sequence is not LONG_STOP_SEQUENCE and performs coding by the selected coding scheme. By doing so, it is possible to select a suitable coding scheme for every frame, improve the coding efficiency, and realize coding with a higher degree of freedom.

### <Description of Decoding Processing>

Furthermore, in the case in which the coding device 11 performs the coding processing described with reference to FIG. 27, the decoding device 71 performs decoding processing depicted in FIG. 28.

The decoding processing performed by the decoding device 71 will be described hereinafter with reference to a flowchart of FIG. 28. It is noted that description of processing of Steps S121 to S123 will be omitted since the processing is similar to the processing of Steps S41 to S43 of FIG. 22. It is to be noted, however, that the determination flag is supplied from the demultiplexing section 82 to the decoding scheme selection section 83 in a case in which the determination flag is extracted from the coded bit stream by demultiplexing in Step S121.

In a case of determining in Step S122 that the window sequence is not LONG_STOP_SEQUENCE, the decoding scheme selection section 83 determines whether or not the MDCT coded data is arithmetic codes on the basis of the determination flag supplied from the demultiplexing section 82 in Step S124. In other words, the decoding scheme selection section 83 determines whether or not the coding scheme of the MDCT coded data is the arithmetic coding.

For example, the decoding scheme selection section 83 determines that the MDCT coded data is not arithmetic codes, that is, Huffman codes in a case in which the value of the determination flag is "1," and determines that the MDCT coded data is arithmetic codes in a case in which the value of the determination flag is "0." In this way, the decoding scheme selection section 83 selects either the Huffman coding or the arithmetic coding that is the decoding scheme corresponding to the coding scheme indicated by the determination flag.

In a case of determining in Step S124 that the MDCT coded data is not arithmetic codes, that is, Huffman codes, the decoding scheme selection section 83 supplies the MDCT coded data and the Huffman code book information which are supplied from the demultiplexing section 82 to the Huffman decoding section 91, and the processing goes to Step S123. The Huffman codes are then decoded in Step S123.

In contrast, in a case of determining in Step S124 that the MDCT coded data is arithmetic codes, the decoding scheme selection section 83 supplies the MDCT coded data supplied from the demultiplexing section 82 to the arithmetic decoding section 92, and the processing goes to Step S125.

In Step S125, the MDCT coded data that is arithmetic codes is decoded by the decoding scheme corresponding to the arithmetic coding. Description of processing of Step S125 will be omitted since the processing is similar to that of Step S44 of FIG. 22.

When the processing of Step S123 or S125 is performed, processing of Steps S126 and S127 is then performed, and the decoding processing is over. However, the description of Steps S126 and S127 will be omitted since the processing is similar to that of Steps S45 and S46 of FIG. 22.

As described so far, the decoding device 71 selects the decoding scheme on the basis of the transform window information and the determination flag and performs decoding. It is particularly possible to not only improve the coding efficiency and reduce the throughput on the decoding side but also realize coding and decoding with a higher degree of freedom since a correct decoding scheme can be selected by referring to the determination flag even for a frame for which the window sequence is not LONG_STOP_SEQUENCE.

### <Third Embodiment>

### <Description of Coding Processing>

Alternatively, in the case of selecting either the Huffman coding or the arithmetic coding for a frame for which the window sequence is not LONG_STOP_SEQUENCE, the coding scheme smaller in the number of necessary bits may be selected.

For example, in a case in which the throughput of the decoding device 71 or the coding device 11 has an allowance and the coding efficiency (compression efficiency) is to take precedence, the numbers of necessary bits for the Huffman coding and the arithmetic coding may be calculated, and the coding scheme smaller in the number of necessary bits may be selected, for a frame for which the window sequence is not LONG_STOP_SEQUENCE.

In such a case, the coding device 11 performs coding processing depicted in, for example, FIG. 29. In other words, the coding processing performed by the coding device 11 will be described below with reference to a flowchart of FIG. 29.

It is noted that description of processing of Steps S151 to S155 will be omitted since the processing is similar to the processing of Steps S11 to S15 of FIG. 20.

In a case of determining in Step S154 that the window sequence is not LONG_STOP_SEQUENCE, the coding scheme selection section 24 supplies the quantized MDCT coefficients supplied from the quantization section 23 to both the Huffman coding section 31 and the arithmetic coding section 32, and the processing goes to Step S156. In this case, it is not determined yet at timing of Step S154 which coding scheme is selected (adopted).

In Step S156, the arithmetic coding section 32 performs context based arithmetic coding on the quantized MDCT coefficients supplied from the coding scheme selection section 24 and supplies the MDCT coded data obtained as a result of coding to the bit control section 26. In Step S156, processing similar to that of Step S16 of FIG. 20 is performed.

In Step S157, the Huffman coding section 31 performs Huffman coding on the quantized MDCT coefficients supplied from the coding scheme selection section 24 and supplies the MDCT coded data and the Huffman code book information which are obtained as a result of coding to the bit control section 26. In Step S157, processing similar to that of Step S1155 is performed.

In Step S158, the bit control section 26 compares the number of bits of the MDCT coded data and the Huffman code book information which are supplied from the Huffman coding section 31 with the number of bits of the MDCT coded data supplied from the arithmetic coding section 32 and selects the coding scheme.

In other words, the bit control section 26 selects the Huffman coding as the coding scheme in a case in which the number of bits (code amount) of the MDCT coded data and the Huffman code book information which are obtained by the Huffman coding is smaller than the number of bits of the MDCT coded data obtained by the arithmetic coding.

In this case, the bit control section 26 supplies the MDCT coded data and the Huffman code book information which are obtained by the Huffman coding to the multiplexing section 27.

In contrast, the bit control section 26 selects the arithmetic coding as the coding scheme in a case in which the number of bits of the MDCT coded data obtained by the arithmetic coding is equal to or smaller than the number of bits of the MDCT coded data and the Huffman code book information which are obtained by the Huffman coding.

In this case, the bit control section 26 supplies the MDCT coded data obtained by the arithmetic coding to the multiplexing section 27.

In this way, comparing the actual number of bits (code amount) in the Huffman coding with that in the arithmetic coding, that is, comparing the numbers of necessary bits in those coding schemes with each other makes it possible to ensure selection of the coding scheme smaller in the number of necessary bits. Substantially, in this case, either the Huffman coding or the arithmetic coding is selected as the coding scheme on the basis of the number of necessary bits at the time of the Huffman coding and the number of necessary bits at the time of the arithmetic coding, and the coding is performed by the selected coding scheme.

In Step S159, the bit control section 26 generates a determination flag according to a selection result of the coding scheme in Step S158 and supplies the generated determination flag to the multiplexing section 27.

For example, the bit control section 26 generates a determination flag having a value "1" in the case of selecting the Huffman coding as the coding scheme and generates a determination flag having a value "0" in the case of selecting the arithmetic coding as the coding scheme.

When the determination flag is generated in this way, the processing then goes to Step S160.

When the processing of Step S159 is performed or the processing of Step S155 is performed, processing of Step S160 is performed, and the coding processing is over. It is noted that description of the processing of Step S160 will be omitted since the processing is similar to that of Step S80 of FIG. 27.

As described so far, the coding device 11 selects the coding scheme smaller in the number of necessary bits from between the Huffman coding and the arithmetic coding for a frame for which the window sequence is not LONG_STOP_SEQUENCE and generates the coded bit stream containing the MDCT coded data coded by the selected coding scheme. By doing so, it is possible to select a suitable coding scheme for every frame, improve the coding efficiency, and realize coding with a higher degree of freedom.

Furthermore, in the case in which the coding processing described with reference to FIG. 29 is performed, the decoding device 71 performs decoding processing described with reference to FIG. 28.

As described so far, according to the present technology, it is possible to improve the coding efficiency (compression efficiency) and reduce the throughput during decoding by appropriately selecting the coding scheme, compared with the case of using only the arithmetic coding.

Furthermore, in the second and third embodiments, it is possible to select a suitable coding scheme for a frame for which the window sequence is not LONG_STOP_SEQUENCE even in the case, for example, in which the bit rate of the audio signal is high and the sound quality is sufficiently high or the case in which the throughput is more important than the sound quality. It is thereby possible to realize coding and decoding with a higher degree of freedom. In other words, it is possible, for example, to control the throughput during decoding more flexibly.

### <Example of Configuration of Computer>

Meanwhile, a series of processing described above can be either executed by hardware or executed by software. In a case of executing the series of processing by the software, a program configuring the software is installed into a computer. Here, types of the computer include a computer incorporated into dedicated hardware, a computer which is, for example, a general-purpose personal computer capable of executing various kinds of functions by installing various kinds of programs into the computer, and the like.

FIG. 30 is a block diagram depicting an example of a configuration of the hardware of the computer causing a program to execute the series of processing described above.

In the computer, a CPU (Central Processing Unit) 501, a ROM (Read Only Memory) 502, and a RAM (Random Access Memory) 503 are mutually connected by a bus 504.

An input/output interface 505 is also connected to the bus 504. An input section 506, an output section 507, a recording section 508, a communication section 509, and a drive 510 are connected to the input/output interface 505.

The input section 506 includes a keyboard, a mouse, a microphone, an imaging element, and the like. The output section 507 includes a display, a speaker, and the like. The recording section 508 includes a hard disk, a nonvolatile memory, and the like. The communication section 509 includes a network interface and the like. The drive 510 drives a removable recording medium 511 such as a magnetic disk, an optical disk, a magneto-optical disk, or a semiconductor memory.

In the computer configured as described above, the CPU 501 loads a program recorded in, for example, the recording section 508 to the RAM 503 via the input/output interface 505 and the bus 504 and executes the program, whereby the series of processing described above are performed.

The program executed by the computer (CPU 501) can be provided by, for example, recording the program in the removable recording medium 511 serving as a package medium or the like. Alternatively, the program can be provided via a wired or wireless transmission medium such as a local area network, the Internet, or a digital satellite service.

In the computer, the program can be installed into the recording section 508 via the input/output interface 505 by loading the removable recording medium 511 into the drive 510. Alternatively, the program can be received by the communication section 509 via the wired or wireless transmission medium and installed into the recording section 508. In another alternative, the program can be installed into the ROM 502 or the recording section 508 in advance.

The program executed by the computer may be a program which performs processing in time series in an order described in the present specification or may be a program which performs the processing either in parallel or at necessary timing such as timing of calling.

Moreover, the embodiments of the present technology are not limited to the embodiments described above, and various changes can be made without departing from the spirit of the present technology.

For example, the present technology can adopt a cloud computing configuration which causes a plurality of devices to process one function in a sharing or cooperative fashion through a network.

Furthermore, each step described in the flowcharts described above can be not only executed by one device but also executed by a plurality of devices in a sharing fashion.

Moreover, when one step includes a plurality of types of processing, the plurality of types of processing included in the one step can be not only executed by one apparatus but also executed by a plurality of devices in a sharing fashion.

Furthermore, the present technology can be configured as follows.
(1) A coding device including:
   a time-frequency transform section that performs time-frequency transform using a transform window on an audio signal; and
   a coding section that performs Huffman coding on frequency spectrum information obtained by the time-frequency transform in a case in which a transform window length of the transform window is changed over from a small transform window length to a large transform window length, and that performs arithmetic coding on the frequency spectrum information in a case in which the transform window length of the transform window is not changed over from the small transform window length to the large transform window length.
(2) The coding device according to (1), further including:
   a multiplexing section that multiplexes coded data regarding the frequency spectrum information and transform window information indicating a type of the transform window used in the time-frequency transform to generate a coded bit stream.
(3) The coding device according to (1) or (2), in which
   the coding section codes the frequency spectrum information by a coding scheme that is either the Huffman coding or the arithmetic coding in the case in which the transform window length of the transform window is not changed over from the small transform window length to the large transform window length.
(4) The coding device according to (3), in which
   the coding section codes the frequency spectrum information by a coding scheme selected on the basis of the number of necessary bits during coding, a bit rate of the audio signal, resource information on a decoding side, or designation information regarding the coding scheme.
(5) The coding device according to (3) or (4), in which
   the multiplexing section multiplexes selection information indicating the coding scheme of the frequency spectrum information, the coded data, and the transform window information to generate the coded bit stream in the case in which the transform window length of the transform window is not changed over from the small transform window length to the large transform window length.
(6) A coding method including:
   by a coding device,
   performing time-frequency transform using a transform window on an audio signal;
   performing Huffman coding on frequency spectrum information obtained by the time-frequency transform in a case in which a transform window length of the transform window is changed over from a small transform window length to a large transform window length; and
   performing arithmetic coding on the frequency spectrum information in a case in which the transform window length of the transform window is not changed over from the small transform window length to the large transform window length.
(7) A program for causing a computer to execute processing including the steps of:
   performing time-frequency transform using a transform window on an audio signal;
   performing Huffman coding on frequency spectrum information obtained by the time-frequency transform in a case in which a transform window length of the transform window is changed over from a small transform window length to a large transform window length; and
   performing arithmetic coding on the frequency spectrum information in a case in which the transform window length of the transform window is not changed over from the small transform window length to the large transform window length.
(8) A decoding device including:
   a demultiplexing section that demultiplexes a coded bit stream, and that extracts transform window information indicating a type of a transform window used in time-frequency transform of an audio signal and coded data regarding frequency spectrum information obtained by the time-frequency transform from the coded bit stream; and
   a decoding section that decodes the coded data by a decoding scheme corresponding to Huffman coding in a case in which the transform window indicated by the transform window information is the transform window selected at a time of changing over the transform window length from a small transform window length to a large transform window length.
(9) The decoding device according to (8), in which
   the decoding section decodes the coded data by a decoding scheme corresponding to arithmetic coding in a case in which the transform window indicated by the transform window information is not the transform window selected at the time of changing over the transform window length from the small transform window length to the large transform window length.
(10) The decoding device according to (8), in which
   the decoding section decodes the coded data by a decoding scheme corresponding to a coding scheme that is either the Huffman coding or arithmetic coding and that is indicated by selection information extracted from the coded bit stream in a case in which the transform window indicated by the transform window information is not the transform window selected at the time of changing over the transform window length from the small transform window length to the large transform window length.
(11) A decoding method including:
   by a decoding device,
   demultiplexing a coded bit stream, and extracting transform window information indicating a type of a transform window used in time-frequency transform of an audio signal and coded data regarding frequency spectrum information obtained by the time-frequency transform from the coded bit stream; and
   decoding the coded data by a decoding scheme corresponding to Huffman coding in a case in which the transform window indicated by the transform window information is the transform window selected at a time of changing over the transform window length from a small transform window length to a large transform window length.
(12) A program for causing a computer to execute processing including the steps of:
   demultiplexing a coded bit stream, and extracting transform window information indicating a type of a transform window used in time-frequency transform of an audio signal and coded data regarding frequency spectrum information obtained by the time-frequency transform from the coded bit stream; and
   decoding the coded data by a decoding scheme corresponding to Huffman coding in a case in which the transform window indicated by the transform window information is the transform window selected at a time of changing over the transform window length from a small transform window length to a large transform window length.

### [Reference Signs List]

11 Coding device, 21 Time-frequency transform section, 24 Coding scheme selection section, 26 Bit control section, 27 Multiplexing section, 31 Huffman coding section, 32 Arithmetic coding section, 71 Decoding device, 81 Acquisition section, 82 Demultiplexing section, 83 Decoding scheme selection section, 91 Huffman decoding section, 92 Arithmetic decoding section

## Claims

1. A decoding device (71), comprising:
a demultiplexing section (82) configured to:
demultiplex a coded bit stream; and
extract transform window information indicating a type of a transform window used in time-frequency transform of an audio signal and coded data regarding frequency spectrum information obtained by the time-frequency transform from the coded bit stream;
a decoding section (84) configured to decode the coded data; and
a decoding scheme selection section (83) configured to select a decoding scheme for the decoding section (84) based on the transform window information,
wherein the decoding scheme selection section (83) is configured to control the decoding section (84) to:
decode the coded data by a decoding scheme corresponding to Huffman coding in a case in which the type of the transform window indicated by the transform window information is a transform window selected at a time of changing over the transform window length from a small transform window length to a large transform window length; and
decode the coded data by a decoding scheme corresponding to arithmetic coding in a case in which the type of the transform window indicated by the transform window information is not the transform window selected at the time of changing over the transform window length from the small transform window length to the large transform window length.

2. The decoding device (71) of claim 1,
wherein the demultiplexing section (82) is further configured to extract parameters associated with normalization from the coded bit stream, and
wherein the decoding device (71) further comprises an inverse quantization section (85) configured to inversely quantize, using the parameters associated with normalization, quantized coefficients supplied from the decoding section (84) as a result of decoding.

3. The decoding device (71) of claim 2, further comprising:
a time-frequency inverse transform section (86) configured to:
perform time-frequency inverse transform on coefficients supplied from the inverse quantization section (85) based on the transform window information; and
output an output audio signal, the output audio signal being a time signal
obtained as a result of time-frequency inverse transform.

4. The decoding device (71) of any one of claims 1 to 3, wherein, in case the decoding section (84) is controlled to decode the coded data by the decoding scheme corresponding to Huffman coding, the decoding section (84) is configured to decode the coded data using Huffman code book information, the Huffman code book information being extracted from the coded bit stream by the demultiplexing section (82).

5. The decoding device (71) of any one of claims 1 to 4, wherein, in the case in which the type of the transform window indicated by the transform window information is not the transform window selected at the time of changing over the transform window length from the small transform window length to the large transform window length, the decoding scheme selection section (83) is further configured to:
determines whether or not the coded data is arithmetic codes based on a determination flag extracted from the coded bit stream by the demultiplexing section (82);
control the decoding section (84) to decode the coded data by the decoding scheme corresponding to arithmetic coding in a case of determining that the coded data is arithmetic codes; and
control the decoding section (84) to decode the coded data by the decoding scheme corresponding to Huffman coding in a case of determining that the coded data is not arithmetic codes.

6. The decoding device (71) of any one of claims 1 to 5, wherein the type of the transform window selected at the time of changing over the transform window length from the small transform window length to the large transform window length is LONG_STOP_SEQUENCE.

7. The decoding device (71) of any one of claims 1 to 6, wherein the coded data is Modified Discrete Cosine Transform, MDCT, coded data.

8. A decoding method for a decoding device, comprising:
demultiplexing, by a demultiplexing section, a coded bit stream;
extracting, by the demultiplexing section, transform window information indicating a type of a transform window used in time-frequency transform of an audio signal and coded data regarding frequency spectrum information obtained by the time-frequency transform from the coded bit stream;
decoding, by a decoding section, the coded data; and
selecting, by a decoding scheme selection section, a decoding scheme for the decoding section (84) based on the transform window information,
wherein, in a case in which the type of the transform window indicated by the transform window information is a transform window selected at a time of changing over the transform window length from a small transform window length to a large transform window length, selecting the decoding scheme comprises controlling the decoding section to decode the coded data by a decoding scheme corresponding to Huffman coding, and
wherein, in a case in which the type of the transform window indicated by the transform window information is not the transform window selected at the time of changing over the transform window length from the small transform window length to the large transform window length, selecting the decoding scheme comprises controlling the decoding section to decode the coded data by a decoding scheme corresponding to arithmetic coding.

9. The decoding method of claim 8, further comprising:
extracting, by the demultiplexing section, parameters associated with normalization from the coded bit stream; and
inversely quantizing, by an inverse quantization section and using the parameters associated with normalization, quantized coefficients supplied from the decoding section as a result of decoding.

10. The decoding method of claim 9, further comprising:
performing, by a time-frequency inverse transform section, time-frequency inverse transform on coefficients supplied from the inverse quantization section based on the transform window information; and
outputting, by the time-frequency inverse transform section, an output audio signal, the output audio signal being a time signal obtained as a result of time-frequency inverse transform.

11. The decoding method of any one of claims 8 to 10, wherein, in case the decoding section (84) is controlled to decode the coded data by the decoding scheme corresponding to Huffman coding, the coded data is decoded using Huffman code book information, the Huffman code book information being extracted from the coded bit stream by the demultiplexing section.

12. The decoding method of any one of claims 8 to 11, wherein, in the case in which the type of the transform window indicated by the transform window information is not the transform window selected at the time of changing over the transform window length from the small transform window length to the large transform window length, selecting the decoding scheme comprises further comprises:
determining, by the decoding scheme selection section, whether or not the coded data is arithmetic codes based on a determination flag extracted from the coded bit stream by the demultiplexing section;
controlling, by the decoding scheme selection section, the decoding section to decode the coded data by the decoding scheme corresponding to arithmetic coding in a case of determining that the coded data is arithmetic codes; and
controlling, by the decoding scheme selection section, the decoding section to decode the coded data by the decoding scheme corresponding to Huffman coding in a case of determining that the coded data is not arithmetic codes.

13. The decoding method of any one of claims 8 to 12, wherein the type of the transform window selected at the time of changing over the transform window length from the small transform window length to the large transform window length is LONG_STOP_SEQUENCE.

14. The decoding method of any one of claims 8 to 13, wherein the coded data is Modified Discrete Cosine Transform, MDCT, coded data.

15. A program for causing a computer to execute the decoding method of any one of claims 8 to 14.
